(19) Europäisches Patentamt
European Patent Office
Office européen des brevets

(11) EP 2 264 219 A1

(12) # EUROPEAN PATENT APPLICATION

published in accordance with Art. 153(4) EPC

(43) Date of publication:
**22.12.2010 Bulletin 2010/51**

(21) Application number: **09725410.6**

(22) Date of filing: **24.03.2009**

(51) Int Cl.:
***C23C 16/42*** *(2006.01)* ***C08G 77/50*** *(2006.01)*
***H01L 21/312*** *(2006.01)* ***H01L 21/316*** *(2006.01)*
***H01L 21/768*** *(2006.01)* ***H01L 23/522*** *(2006.01)*

(86) International application number:
**PCT/JP2009/055825**

(87) International publication number:
**WO 2009/119583 (01.10.2009 Gazette 2009/40)**

(84) Designated Contracting States:
**AT BE BG CH CY CZ DE DK EE ES FI FR GB GR HR HU IE IS IT LI LT LU LV MC MK MT NL NO PL PT RO SE SI SK TR**
Designated Extension States:
**AL BA RS**

(30) Priority: **26.03.2008 JP 2008079734**
**12.05.2008 JP 2008124327**
**03.09.2008 JP 2008225736**
**03.09.2008 JP 2008225735**
**11.09.2008 JP 2008233115**

(71) Applicant: **JSR Corporation**
**Minato-ku**
**Tokyo 105-8640 (JP)**

(72) Inventors:
- **NAKAGAWA, Hisashi**
**Tokyo 105-8640 (JP)**
- **NOBE, Yohei**
**Tokyo 105-8640 (JP)**
- **CHUNG, Kang-go**
**Tokyo 105-8640 (JP)**
- **SAITO, Ryuichi**
**Tokyo 105-8640 (JP)**
- **KOKUBO, Terukazu**
**Tokyo 105-8640 (JP)**

(74) Representative: **TBK-Patent**
**Bavariaring 4-6**
**80336 München (DE)**

(54) **MATERIAL FOR CHEMICAL VAPOR DEPOSITION, SILICON-CONTAINING INSULATING FILM AND PROCESS FOR PRODUCTION THEREOF**

(57) A chemical vapor deposition material includes an organosilane compound shown by the following general formula (1).

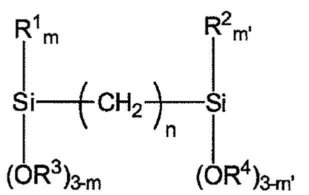

(1)

wherein $R^1$ and $R^2$ individually represent a hydrogen atom, an alkyl group having 1 to 4 carbon atoms, a vinyl group, or a phenyl group, $R^3$ and $R^4$ individually represent an alkyl group having 1 to 4 carbon atoms, an acetyl group, or a phenyl group, m is an integer from 0 to 2, and n is an integer from 1 to 3.

EP 2 264 219 A1

## Description

### TECHNICAL FIELD

The present invention relates to a chemical vapor deposition material, a silicon-containing insulating film, and a method of producing the silicon-containing insulating film.

### BACKGROUND ART

In recent years, an increase in processing speed has been strongly desired for ultra-large scale integration (ULSI) circuits in order to deal with an increase in the processing of target information and the degree of functional complexity. An increase in ULSI processing speed has been implemented by reducing the size of elements provided in a chip, increasing the degree of integration of elements, and forming a multi-layer film. However, an increase in wiring resistance and wiring parasitic capacitance occurs due to a reduction in size of elements, so that a wiring delay predominantly causes a signal delay in the entire device. In order to prevent this problem, it is indispensable to use a low-resistivity wiring material or a low-dielectric-constant (low-k) interlayer dielectric material.

Examples of such a low-dielectric-constant interlayer dielectric include a porous silica film formed by reducing the film density of silica ($SiO_2$), an inorganic interlayer dielectric such as a silica film doped with F (FSG) and an SiOC film doped with C, and an organic interlayer dielectric such as a polyimide, polyarylene, and polyarylene ether. Interlayer dielectrics that have been widely used are generally deposited by chemical vapor deposition (CVD). Therefore, various films deposited by CVD have been proposed. In particular, various films characterized by a silane compound used for reactions have been proposed. For example, a film that utilizes a dialkoxysilane has been proposed (JP-A-11-288931 and JP-A-2002-329718). A film having a low dielectric constant and excellent adhesion to a barrier metal or the like may be obtained using such a material.

However, such a silane compound may require extreme conditions during CVD due to chemical stability, or may undergo a reaction in a pipe connected to a CVD chamber due to chemical instability, or may exhibit poor storage stability. The resulting insulating film may exhibit high hygroscopicity depending on the selected compound, so that a leakage current may increase. A semiconductor device production process generally involves a step that processes an interlayer dielectric using reactive ion etching (RIE). The dielectric constant of a film may increase during RIE, or an interlayer dielectric may be damaged by a fluorine acid-based chemical used in the subsequent washing step. Therefore, an interlayer dielectric having high process resistance has been desired.

The applicant of this application has reported that a film that exhibits excellent process resistance can be obtained when using a compound in which two silicon atoms are bonded via a carbon chain, only a monovalent hydrocarbon group being bonded to one of the two silicon atoms, and one or two alkoxy groups being bonded to the other silicon atom. However, the resulting film exhibits insufficient mechanical strength. Therefore, development of an interlayer dielectric that exhibits improved strength and process resistance has been desired.

JP-A-2007-318067 discloses a CVD compound in which two silicon atoms are bonded via a carbon chain and substituted with an alkoxy group. However, the examples of JP-A-2007-318067 utilize only a compound in which two silicon atoms are bonded via a vinylene group. Such a compound may not necessarily exhibit excellent process resistance.

The applicant of this application recently found that a film that exhibits excellent process resistance can be obtained when using a compound in which two silicon atoms are bonded via a carbon chain, only a monovalent hydrocarbon group being bonded to one of the two silicon atoms, and one or two alkoxy groups being bonded to the other silicon atom (WO2008/020592). However, the resulting film exhibits insufficient mechanical strength. Therefore, development of an interlayer dielectric that exhibits improved strength and process resistance has been desired.

### DISCLOSURE OF THE INVENTION

The invention may provide a silicon-containing insulating film that has a low relative dielectric constant, high process resistance, and excellent mechanical strength, a method of producing the same, and a chemical vapor deposition material that may form the silicon-containing insulating film.

The inventors of the invention found that an organosilane compound that has a silicon-carbon-silicon skeleton and has a specific structure in which oxygen is bonded to one of the silicon atoms is chemically stable and is suitable for CVD, and an interlayer dielectric material having a low relative dielectric constant, low hygroscopicity, and high process resistance is obtained using the organosilane compound.

According to one aspect of the invention, there is provided a chemical vapor deposition material comprising an organosilane compound shown by the following general formula (1),

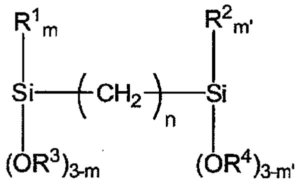

(1)

wherein $R^1$ and $R^2$ individually represent a hydrogen atom, an alkyl group having 1 to 4 carbon atoms, a vinyl group, or a phenyl group, $R^3$ and $R^4$ individually represent an alkyl group having 1 to 4 carbon atoms, an acetyl group, or a phenyl group, m and m' are individually integers from 0 to 2, and n is an integer from 1 to 3.

It is preferable that m=m', and more preferably m=m'=1 or 2.

It is also preferable that m=0 and m'=1.

It is also preferable that m=2 and m'=0 or 1.

In the above chemical vapor deposition material, n may be 1.

The above chemical vapor deposition material may be used to form an insulating film that includes silicon, carbon, oxygen, and hydrogen.

The above chemical vapor deposition material may have a content of elements other than silicon, carbon, oxygen, and hydrogen of less than 10 ppb, and a water content of less than 0.1%.

According to another aspect of the invention, there is provided a silicon-containing insulating film formed by using the above chemical vapor deposition material.

According to another aspect of the invention, there is provided a method of producing a silicon-containing insulating film, the method comprising: depositing the above chemical vapor deposition material on a substrate by chemical vapor deposition to form a deposited film; and curing the deposited film by at least one means selected from heating, electron beam irradiation, ultraviolet irradiation, and oxygen plasma irradiation.

According to a further aspect of the invention, there is provided a method of producing a silicon-containing insulating film comprising supplying the above chemical vapor deposition material and a pore-forming agent to a substrate by chemical vapor deposition to form a deposited film.

According to a still further aspect of the invention, there is provided a silicon-containing insulating film obtained by any one of the above methods of producing a silicon-containing insulating film.

The above silicon-containing insulating film may include an $-Si-(CH_2)_n-Si-O-$site, wherein n is an integer from 1 to 3.

The above silicon-containing insulating film may have a dielectric constant of 3.0 or less.

Since the above chemical vapor deposition material includes the organosilane compound shown by the general formula (1), the chemical vapor deposition material can be suitably used for semiconductor devices for which an increase in degree of integration and the number of layers has been desired, is suitable for CVD, and may be used to form an interlayer dielectric having excellent mechanical strength, a low relative dielectric constant, low hygroscopicity, and high process resistance.

Although the detailed mechanism is unknown, it is conjectured that the $R^1_m-Si-(CH_2)_n-Si-R^2_{m'}$ site of the organosilane compound shown by the general formula (1) reduces damage due to RIE, and increases resistance to a hydrofluoric acid-based chemical, and the $-Si-(OR^3)_{3-m}$ site and the $-Si-(OR^4)_{3-m'}$ site of the organosilane compound form an -Si-O-Si- bond to form a three-dimensional skeleton that has a high degree of crosslinking, so that an insulating film having excellent mechanical strength, a low relative dielectric constant, and high process resistance is obtained.

The above silicon-containing insulating film has excellent mechanical strength, a low relative dielectric constant, and high process resistance.

An insulating film that has excellent mechanical strength, a low relative dielectric constant, and high process resistance is obtained by the above method of producing a silicon-containing insulating film.

## BEST MODE FOR CARRYING OUT THE INVENTION

The invention is described in detail below.

1. Chemical vapor deposition material and method of producing the same

1.1. Chemical vapor deposition material (first embodiment)

A chemical vapor deposition material according to one embodiment of the invention includes an organosilane

compound (hereinafter may be referred to as "compound 1") shown by the following general formula (1).

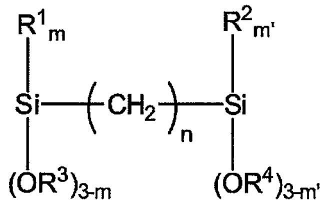

wherein $R^1$ and $R^2$ individually represent a hydrogen atom, an alkyl group having 1 to 4 carbon atoms, a vinyl group, or a phenyl group, $R^3$ and $R^4$ individually represent an alkyl group having 1 to 4 carbon atoms, an acetyl group, or a phenyl group, m and m' are individually integers from 0 to 2, and n is an integer from 1 to 3.

In the general formula (1), it is preferable that (i) m=m' (more preferably m=m'=1 or 2 from the viewpoint of obtaining a film that exhibits more excellent mechanical strength) (case (i)), (ii) m=0 and m'=1 (case (ii)), or (iii) m=2 and m'=0 or 1 (case (iii)).

$R^1$ and $R^2$ in the general formula (1) individually represent a hydrogen atom, an alkyl group having 1 to 4 carbon atoms, a vinyl group, or a phenyl group. Examples of the alkyl group having 1 to 4 carbon atoms include a methyl group, an ethyl group, an n-propyl group, an isopropyl group, an n-butyl group, an isobutyl group, a tert-butyl group, and the like. $R^1$ and $R^2$ are particularly preferably a methyl group, a vinyl group, or a hydrogen atom.

$R^3$ and $R^4$ in the general formula (1) individually represent an alkyl group having 1 to 4 carbon atoms, an acetyl group, or a phenyl group. Examples of the alkyl group having 1 to 4 carbon atoms include the alkyl groups mentioned in connection with $R^1$ and $R^2$. $R^3$ and $R^4$ are particularly preferably a methyl group or an ethyl group. It is preferable that $R^3$ and $R^4$ be identical.

In the general formula (1), it is preferable that n=1 from the viewpoint of obtaining a film that exhibits more excellent mechanical strength and excellent process resistance.

In the organosilane compound shown by the general formula (1), it is preferable that the total number of hydrogen atoms included in $R^1$ and $R^2$ be 0 to 2, and more preferably 0 or 1, from the viewpoint of ease of synthesis, purification, and handling. It is preferable that the total number of hydrogen atoms included in $R^1$ and $R^2$ be 1 or 2 from the viewpoint of decreasing the boiling point of the organosilane compound and increasing the mechanical strength of the resulting silicon-containing film.

1.1.1. Case (i)

In the organosilane compound shown by the general formula (1) according to the case (i), the degrees of substitution of the silicon atoms of the organosilane compound are symmetrical. Specifically, the silicon atoms of the organosilane compound shown by the general formula (1) are substituted with an identical number of OR groups (wherein R represents a hydrogen atom, an alkyl group having 1 to 4 carbon atoms, a vinyl group, or a phenyl group). A film that exhibits uniformly balanced process resistance and mechanical strength over the entire film can be obtained using the organosilane compound according to the case (i).

Examples of the organosilane compounds shown by the general formula (1) in which n=1 and m=m'=0 include the following compounds.

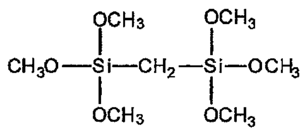

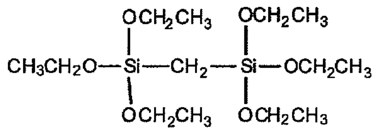

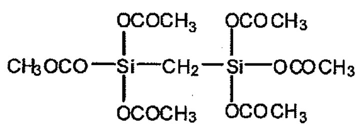

Examples of the organosilane compounds shown by the general formula (1) in which n=1 and m=m'=1 include the following compounds.

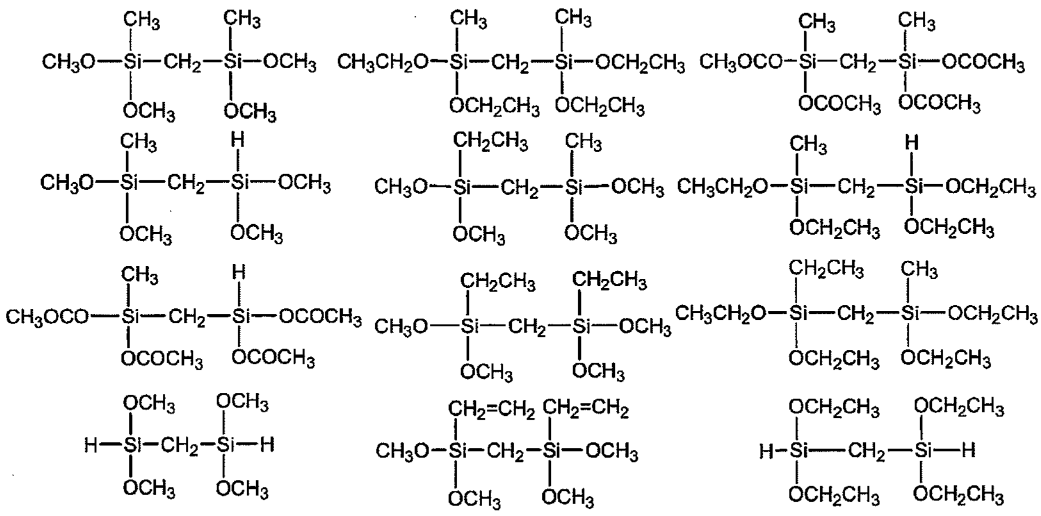

Examples of the organosilane compounds shown by the general formula (1) in which n=1 and m=m'=2 include the following compounds.

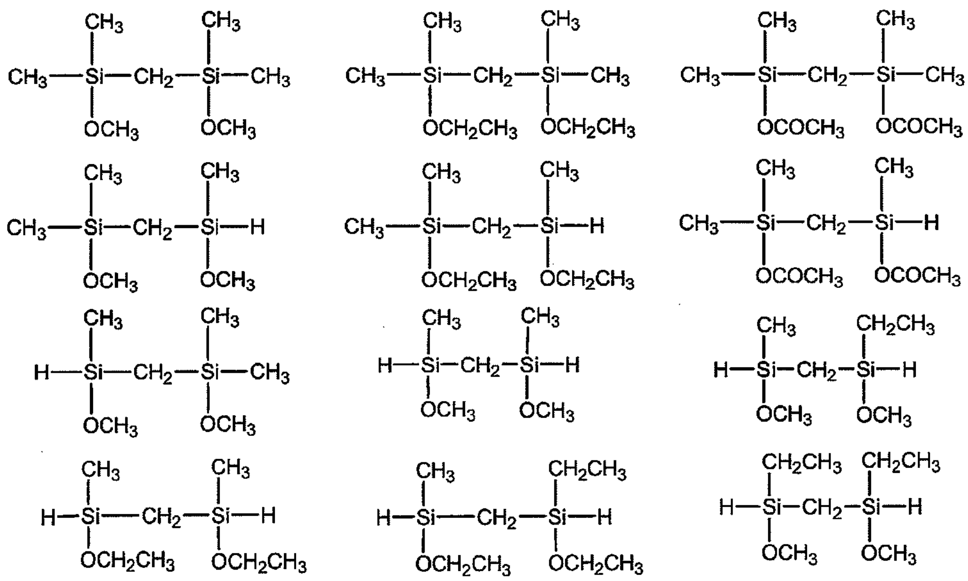

Examples of the organosilane compounds shown by the general formula (1) in which n=2 and m=m'=0 include the following compounds.

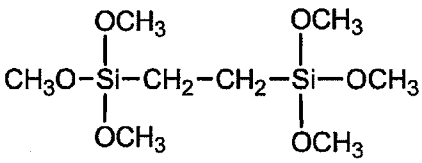

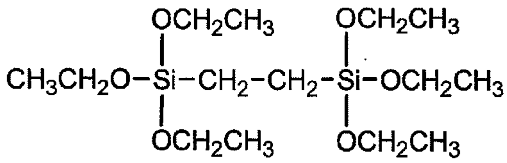

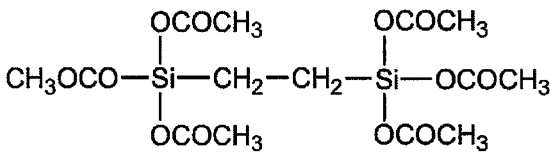

Examples of the organosilane compounds shown by the general formula (1) in which n=2 and m=m'=1 include the following compounds.

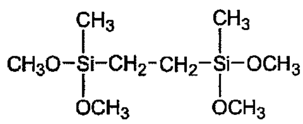

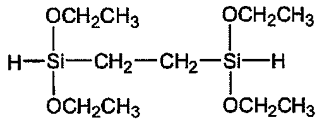

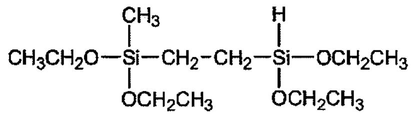

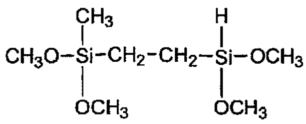

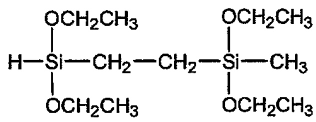

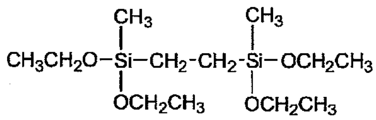

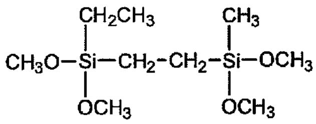

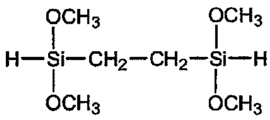

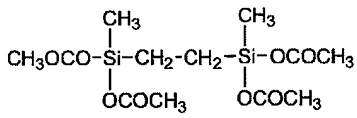

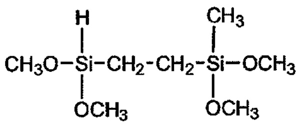

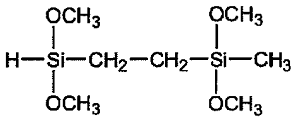

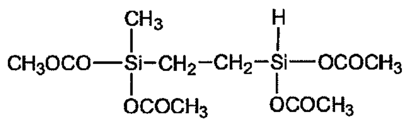

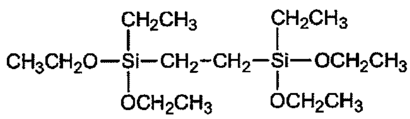

Examples of the organosilane compounds shown by the general formula (1) in which n=2 and m=m'=2 include the following compounds.

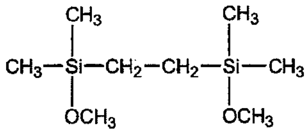
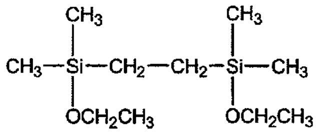
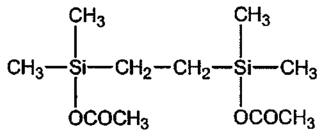
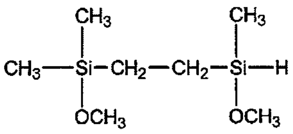
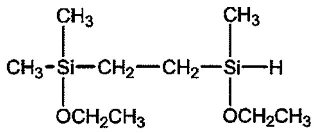
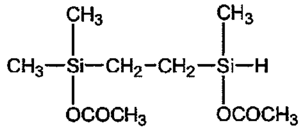
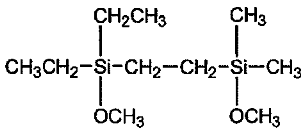
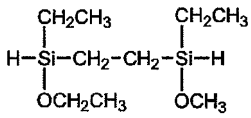
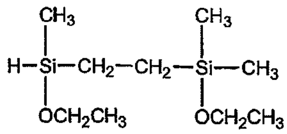
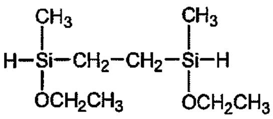
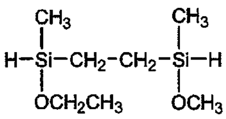
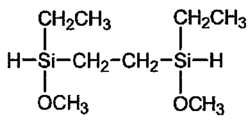
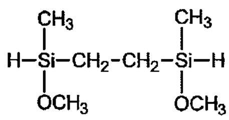

Examples of the organosilane compounds shown by the general formula (1) in which n=3 and m=m'=0 include the following compounds.

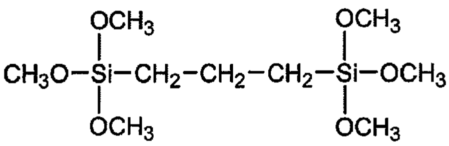
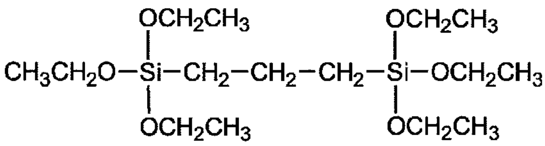
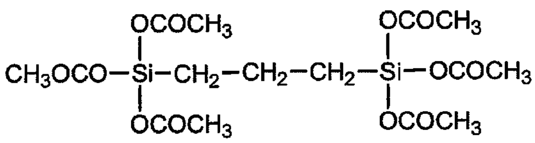

Examples of the organosilane compounds shown by the general formula (1) in which n=3 and m=m'=1 include the following compounds.

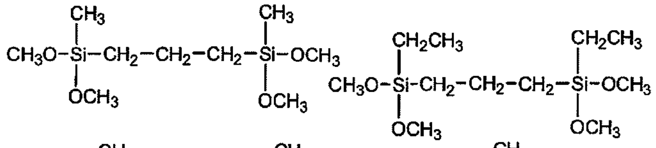
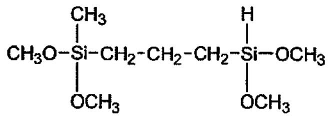
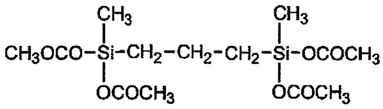
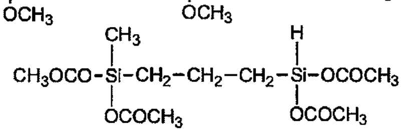
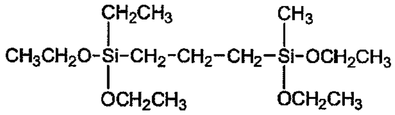
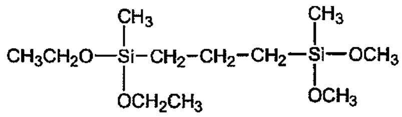
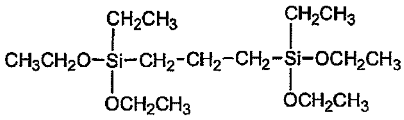
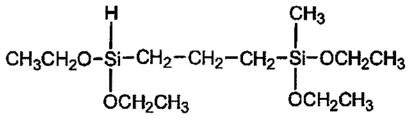
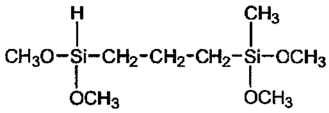
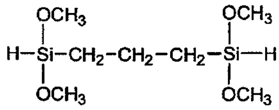

Examples of the organosilane compounds shown by the general formula (1) in which n=3 and m=m'=2 include the following compounds.

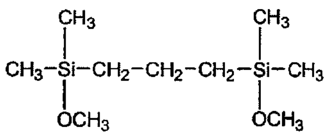
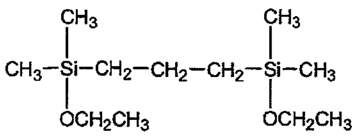
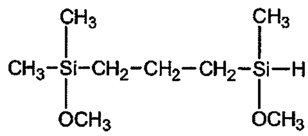
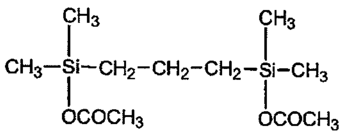
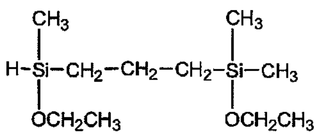
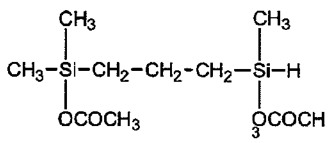
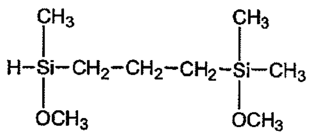
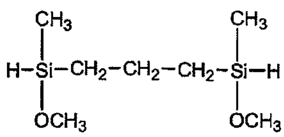
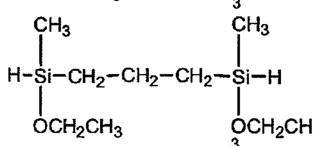
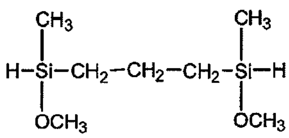
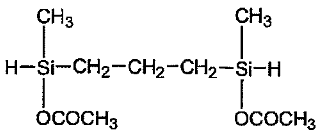
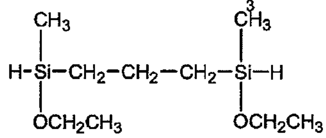
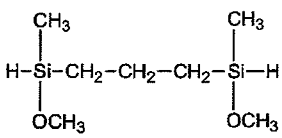
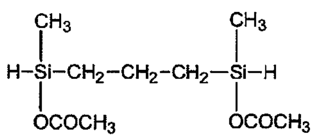
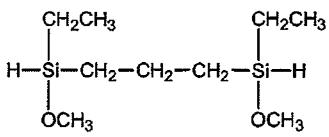

1.1.2. Case (ii)

An insulating film obtained using the organosilane compound according to the case (ii) exhibits excellent mechanical strength, a low dielectric constant, and high process resistance. Although the detailed mechanism is unknown, it is conjectured that the $-Si-(OR^3)_3$ site and the $-Si-(OR^4)_2$ site of the organosilane compound shown by the general

formula (1) form an -Si-O-Si- bond to form a three-dimensional skeleton that has a high degree of crosslinking and increases mechanical strength. It is conjectured that the -Si-$(CH_2)_n$-Si-$R^2$ site reduces damage due to RIE, and increases resistance to a hydrofluoric acid-based chemical.

In the organosilane compound shown by the general formula (1) according to the case (ii), it is preferable that $R^1$ be a hydrogen atom from the viewpoint of decreasing the boiling point of the organosilane compound and increasing the mechanical strength of the resulting silicon-containing film. On the other hand, it is preferable that $R^1$ be a group other than a hydrogen atom from the viewpoint of ease of synthesis, purification, and handling.

Examples of the organosilane compounds shown by the general formula (1) in which n=1, m=0, and m'=1 include the following compounds.

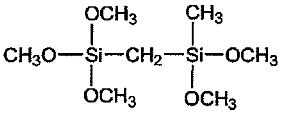
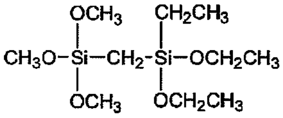
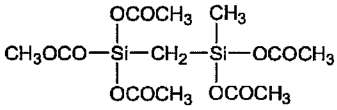
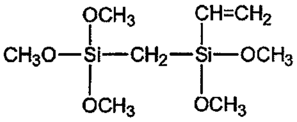
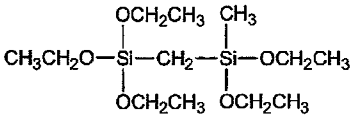
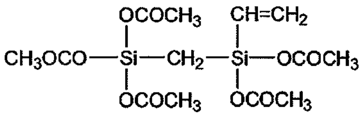
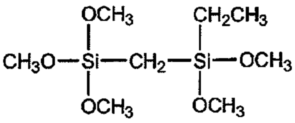
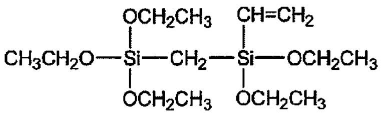
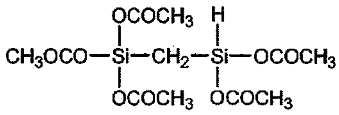
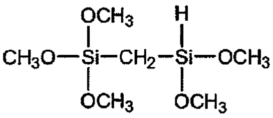
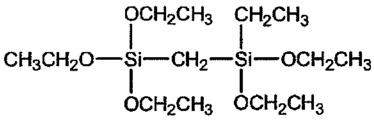
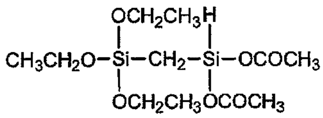
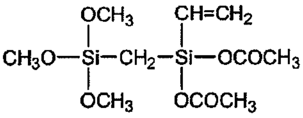
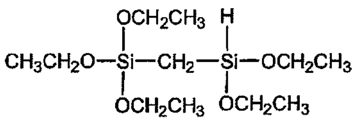

Examples of the organosilane compounds shown by the general formula (1) in which n=2, m=0, and m'=1 include the following compounds.

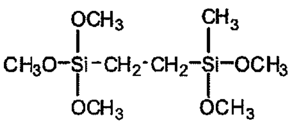
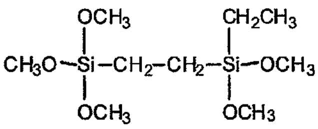
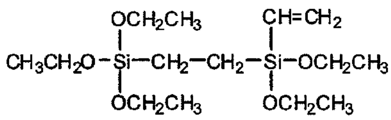
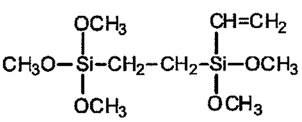
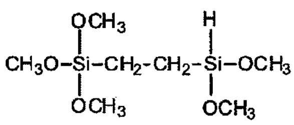
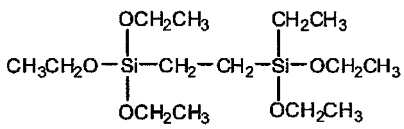
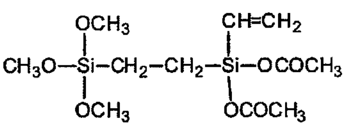
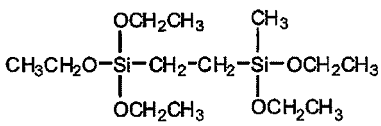
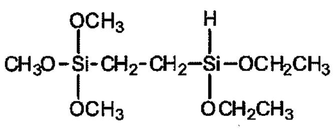
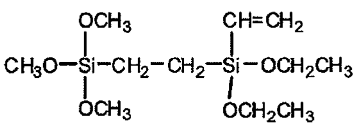

Examples of the organosilane compounds shown by the general formula (1) in which n=3, m=0, and m'=1 include the following compounds.

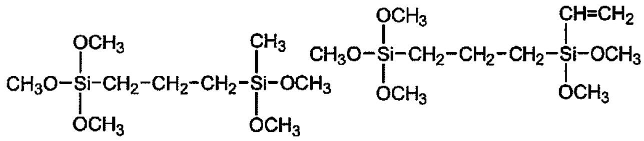
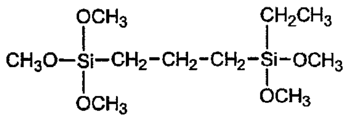
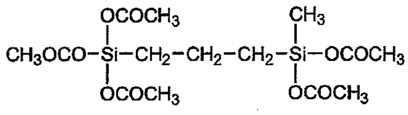
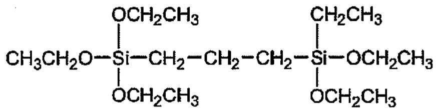
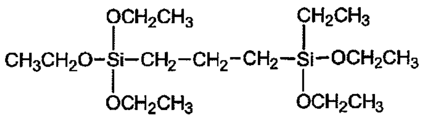
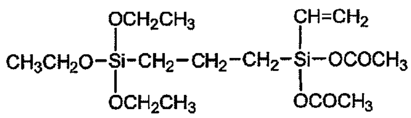

1.1.3. Case (iii)

In the organosilane compound shown by the general formula (1) according to the case (iii), only two substituents of one of the silicon atoms or two substituents of one of the silicon atoms and one substituent of the other silicon atom are substituted with a hydrogen atom, an alkyl group having 1 to 4 carbon atoms, a vinyl group, or a phenyl group. The oxygen atoms are bonded to one substituent of one of the silicon atoms, and two or three substituents of the other silicon atom.

Although the detailed mechanism is unknown, it is conjectured that the $R^1{}_2$-Si-$(CH_2)_n$-Si site of the organosilane compound shown by the general formula (1) according to the case (iii) reduces damage due to RIE, and increases resistance to a hydrofluoric acid-based chemical. It is conjectured that the -Si-$OR^2$ site and the -Si-$(OR^4)_m$ site form an -Si-O-Si- bond to form a three-dimensional skeleton that has a high degree of crosslinking, so that an insulating film that exhibits excellent mechanical strength, a low relative dielectric constant, and high process resistance isobtained.

In the organosilane compound according to the case (iii), it is preferable that m in the general formula (1) be 3 from the viewpoint of obtaining a film that exhibits more excellent mechanical strength.

In the organosilane compound according to the case (iii), it is preferable that the total number of hydrogen atoms included in $R^1$ and $R^3$ in the general formula (1) be 0 to 2, and more preferably 0 or 1, from the viewpoint of ease of synthesis, purification, and handling. It is preferable that the total number of hydrogen atoms included in $R^1$ and $R^3$ be 1 or 2 from the viewpoint of decreasing the boiling point of the organosilane compound and increasing the mechanical strength of the resulting film.

Examples of the organosilane compounds shown by the general formula (1) in which n=1, m=2, and m'=1 include the following compounds.

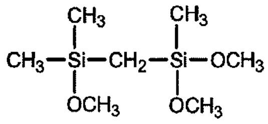
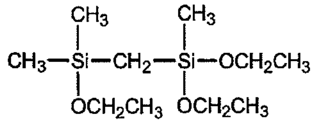
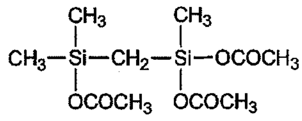
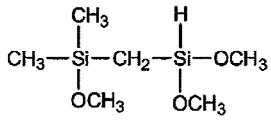
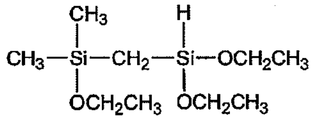
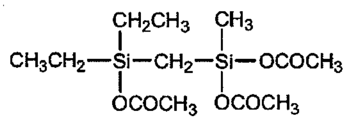
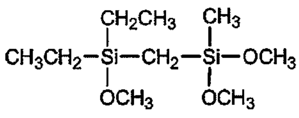
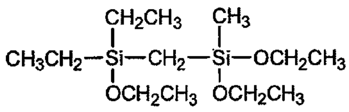
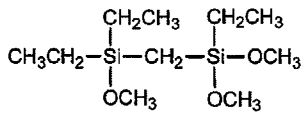
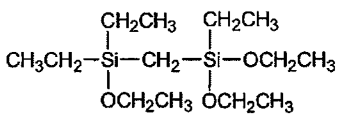
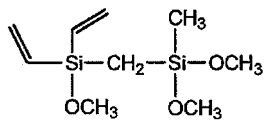

Examples of the organosilane compounds shown by the general formula (1) in which n=1, m=2, and m'=0 include the following compounds.

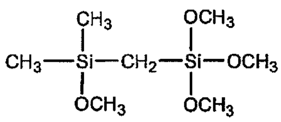
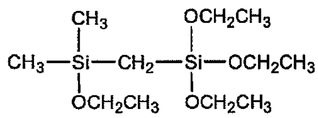
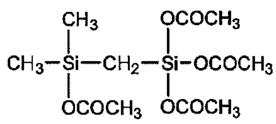
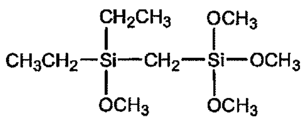
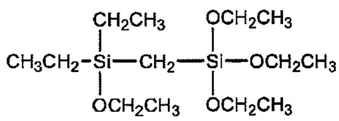
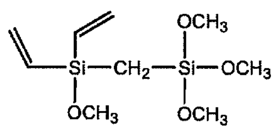
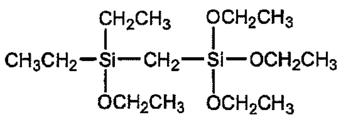
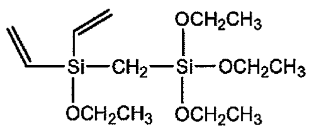

Examples of the organosilane compounds shown by the general formula (1) in which n=2, m=2, and m'=1 include the following compounds.

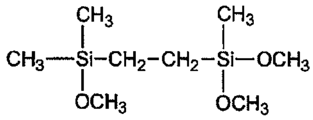
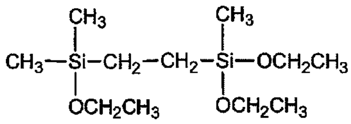
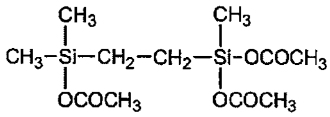
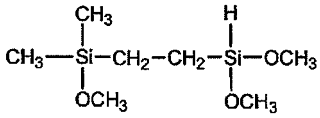
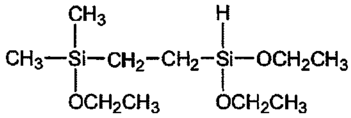
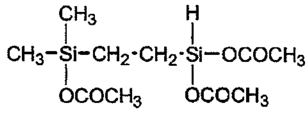
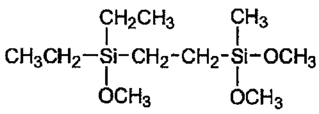
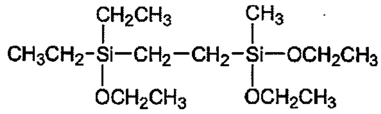
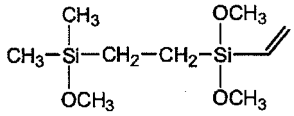
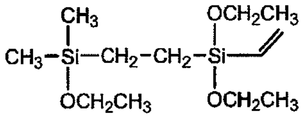
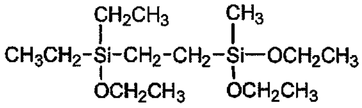
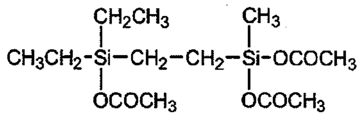
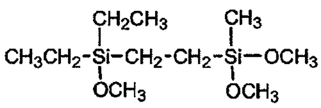
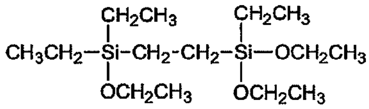

Examples of the organosilane compounds shown by the general formula (1) in which n=2, m=2, and m'=0 include the following compounds.

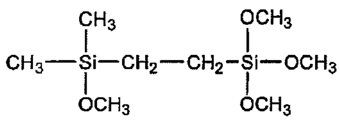
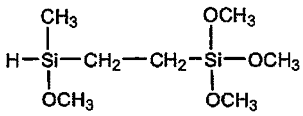
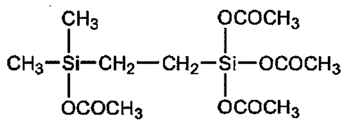
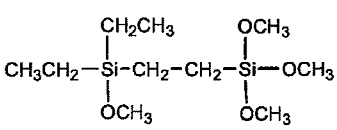
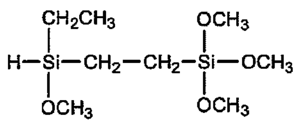
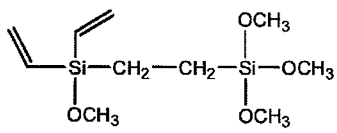
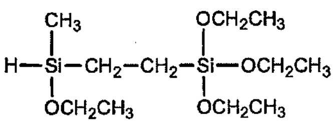
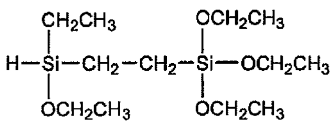

Examples of the organosilane compounds shown by the general formula (1) in which n=3, m=2, and m'=1 include the following compounds.

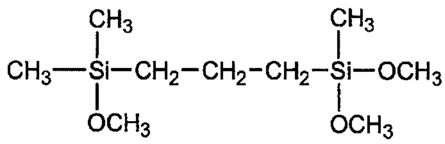
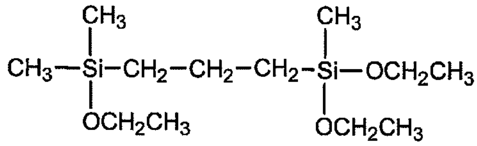
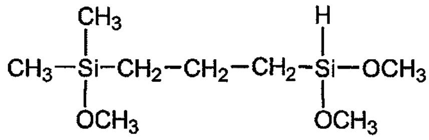
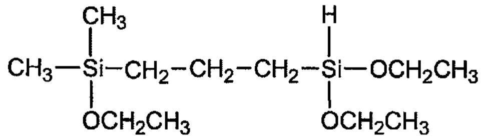
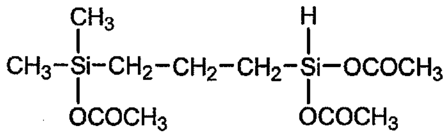
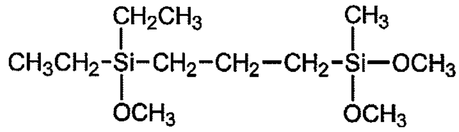
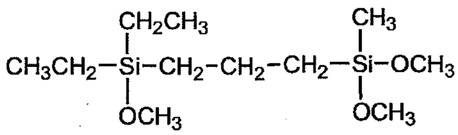
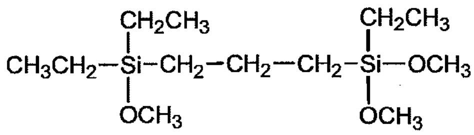
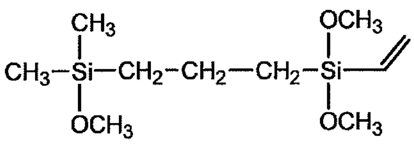

Examples of the organosilane compounds shown by the general formula (1) in which n=3, m=2, and m'=0 include the following compounds.

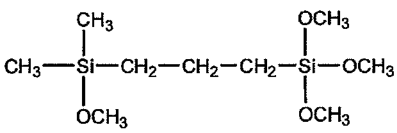
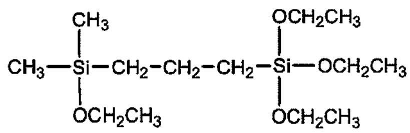
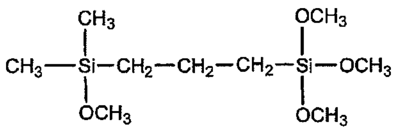
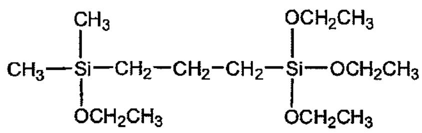
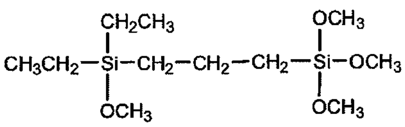

The chemical vapor deposition material according to one embodiment of the invention preferably mainly includes the organosilane compound shown by the general formula (1). The chemical vapor deposition material according to one embodiment of the invention may include components other than the organosilane compound shown by the general formula (1). The chemical vapor deposition material according to one embodiment of the invention preferably includes the organosilane compound shown by the general formula (1) in an amount of 30 to 100%.

The chemical vapor deposition material according to one embodiment of the invention may be used to form an insulating film that includes silicon, carbon, oxygen, and hydrogen. Such an insulating film exhibits high resistance to a hydrofluoric acid-based chemical that is widely used for a cleaning (washing) step during a semiconductor production process (i.e., exhibits high process resistance).

When using the chemical vapor deposition material according to one embodiment of the invention that includes the organosilane compound shown by the general formula (1) as an insulating film-forming material, it is preferable that the chemical vapor deposition material have a content of elements (hereinafter may be referred to as "impurities") other than silicon, carbon, oxygen, and hydrogen of less than 10 ppb and a water content of less than 0.1%. An insulating film that has a low relative dielectric constant and excellent process resistance can be obtained in high yield by forming an insulating film using such an insulating film-forming material.

1.2. Additional silane compound

The chemical vapor deposition material according to one embodiment of the invention may include at least one silane compound (hereinafter may be referred to as "component (II)") selected from a silane compound shown by the following general formula (2) (hereinafter may be referred to as "compound 2"), a silane compound shown by the following general formula (3) (hereinafter may be referred to as "compound 3"), and a silane compound shown by the following general formula (4) (hereinafter may be referred to as "compound 4"). The compounds 2 to 4 may be used individually or in combination. The chemical vapor deposition material according to one embodiment of the invention may further include a pore-forming agent described later together with the component (II).

$$R^6{}_aSi(OR^7)_{4-a} \qquad (2)$$

wherein $R^6$ individually represents a hydrogen atom, a fluorine atom, or a monovalent organic group, $R^7$ individually represents a monovalent organic group, and a is an integer from 0 to 4.

$$R^8{}_b(R^9O)_{3-b}Si\text{-}O_e\text{-}Si(OR^{10})_{3-c}R^{11}{}_c \qquad (3)$$

wherein $R^8$ to $R^{11}$ individually represent a hydrogen atom, a fluorine atom, or a monovalent organic group, b and c are individually integers from 0 to 3, and e is 0 or 1.

$$\left[ R^{13}{}_f(R^{14}O)_{2-f}Si\text{-}(R^{15})_g \right]_h \qquad (4)$$

wherein $R^{13}$ and $R^{14}$ individually represent a hydrogen atom, a fluorine atom, or a monovalent organic group, $R^{15}$ represents an oxygen atom, a phenylene group, or a group shown by $-(CH_2)_n-$ (wherein n is an integer from 1 to 6), f is an integer from 0 to 2, g is 0 or 1, and h is an integer from 2 to 30.

When the chemical vapor deposition material according to one embodiment of the invention includes the component (II), the content of the compound 1 (hereinafter may be referred to as "component (I)") is 10 to 90 mol%, and preferably 15 to 85 mol%, based on the total content (100 mol%) of the components (I) and (II).

When the chemical vapor deposition material according to one embodiment of the invention includes the pore-forming agent, the content of the pore-forming agent is preferably 0.05 to 10,000 parts by weight, and more preferably 0.1 to 5000 parts by weight, based on 100 parts by weight of the component (I), from the viewpoint of obtaining a uniform film that has a low relative dielectric constant.

In a method of forming a silicon-containing insulating film according to one embodiment of the invention, the component (I) is used in an amount of 10 to 90 mol%, and preferably 15 to 85 mol%, based on the total content (100 mol%) of the components (I) and (II).

Since the composition (chemical vapor deposition material) according to the first embodiment includes the compound 1, the composition may be used to form an insulating film that includes silicon, carbon, oxygen, and hydrogen. Such an insulating film exhibits high resistance to a hydrofluoric acid-based chemical that is widely used for a cleaning (washing) step during a semiconductor production process (i.e., exhibits high process resistance).

Since the composition (chemical vapor deposition material) according to the second embodiment further includes at least one compound selected from the compounds 2 to 4 of which the number of crosslinking substituents is larger than that of the compound 1, an insulating film that exhibits more excellent mechanical strength and a low relative dielectric constant can be formed using the composition according to the second embodiment.

1.2.1. Compound 2

Examples of the monovalent organic group represented by $R^6$ and $R^7$ in the general formula (2) include an alkyl group, an alkenyl group, an aryl group, an allyl group, a glycidyl group, and the like. Among these, an alkyl group

or a phenyl group is preferable as the monovalent organic group represented by $R^6$ and $R^7$.

Examples of the alkyl group include a methyl group, an ethyl group, a propyl group, a butyl group, and the like. The number of carbon atoms of the alkyl group is preferably 1 to 5. The alkyl group may be either linear or branched. A hydrogen atom of the alkyl group may be substituted with a fluorine atom or the like. Examples of the aryl group include a phenyl group, a naphthyl group, a methylphenyl group, an ethylphenyl group, a chlorophenyl group, a bromophenyl group, a fluorophenyl group, and the like. Examples of the alkenyl group include a vinyl group, a propenyl group, a 3-butenyl group, a 3-pentenyl group, a 3-hexenyl group, and the like.

Specific examples of the compound 2 include tetramethoxysilane, tetraethoxysilane, trimethoxysilane, triethoxysilane, methyltrimethoxysilane, methyltriethoxysilane, methyltri-n-propoxysilane, methyltri-iso-propoxysilane, ethyltrimethoxysilane, ethyltriethoxysilane, phenyltrimethoxysilane, phenyltriethoxysilane, methyldimethoxysilane, methyldiethoxysilane, dimethyldimethoxysilane, dimethyldiethoxysilane, diethyldimethoxysilane, diethyldiethoxysilane, diphenyldimethoxysilane, diphenyldiethoxysilane, dimethylmethoxysilane, dimethylethoxysilane, trimethylmethoxysilane, trimethylethoxysilane, trimethyl-n-propoxysilane, triethylmethoxysilane, triethylethoxysilane, triethyl-n-propoxysilane, triphenylmethoxysilane, triphenyl-ethoxysilane, triphenyl-n-propoxysilane, trimethylsilane, tetramethylsilane, and the like.

These compounds 2 may be used either individually or in combination.

1.2.2. Compound 3

Examples of the monovalent organic group represented by $R^8$ to $R^{11}$ in the general formula (3) include the groups mentioned in connection with $R^6$ and $R^7$ in the general formula (2).

Preferable examples of the compound 3 include hexamethoxydisilane, hexaethoxydisilane, 1,1,2,2-tetramethoxy-1,2-dimethyldisilane, 1,1,2,2-tetraethoxy-1,2-dimethyldisilane, 1,1,2,2-tetramethoxy-1,2-diphenyldisilane, 1,2-dimethoxy-1,1,2,2-tetramethyldisilane, 1,2-diethoxy-1,1,2,2-tetramethyldisilane, 1,2-dimethoxy-1,1,2,2-tetraphenyldisilane, 1,1,3,3-tetramethyl-1,3-dimethoxydisiloxane, 1,1,3,3-tetramethoxy-1,3-dimethyldisiloxane, hexamethyldisiloxane, hexamethoxydisiloxane, hexaethoxydisiloxane, 1,1,3,3-tetramethoxy-1,3-dimethyldisiloxane, 1,1,3,3-tetraethoxy-1,3-dimethyldisiloxane, 1,1,3,3-tetramethoxy-1,3-diphenyldisiloxane, 1,3-dimethoxy-1,1,3,3-tetramethyldisiloxane, 1,3-diethoxy-1,1,3,3-tetramethyldisiloxane, 1,3-dimethoxy-1,1,3,3-tetraphenyldisiloxane, 1,3-diethoxy-1,1,3,3-tetraphenyldisiloxane, and the like.

These compounds 3 may be used either individually or in combination.

1.2.3. Compound 4

The compound 4 is an oligomer that includes the repeating structure shown by the general formula (4), and may have a cyclic structure.

Examples of the monovalent organic group represented by $R^{13}$ and $R^{14}$ in the general formula (4) include the groups mentioned in connection with $R^6$ and $R^7$ in the general formula (2).

Preferable examples of the compound 4 include octamethyltrisilane, octaethyltrisilane, 1,2,3-trimethoxy-1,1,2,3,3-pentamethyltrisilane, 1,2,3-trimethoxy-1,1,2,3,3-pentaethyltrisilane, octamethoxytrisilane, octaethoxytrisilane, 1,3,5,7-tetramethylcyclotetrasiloxane, 1,1,3,3,5,5,7,7-octamethylcyclotetrasiloxane, and the like.

These compounds 4 may be used either individually or in combination.

1.3. Method of producing organosilane compound

The organosilane compounds shown by the general formula (1) may be produced by the following first or second method, for example.

1.3.1. First method

The first method includes allowing an organosilane compound shown by the following general formula (5) and an organosilane compound shown by the following general formula (6) to undergo a coupling reaction in the presence of a metal, reacting a hydrogen halide with the resulting product to substitute the phenyl group with a halogen atom, and substituting the halogen atom with an alkoxy group using a trialkyl orthoformate, or directly reacting an alcohol with the resulting product in the presence of an organic amine.

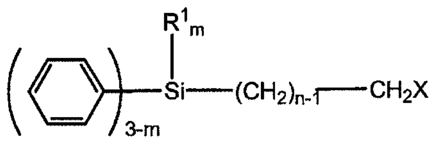

(5)

wherein $R^1$ individually represents a hydrogen atom, an alkyl group having 1 to 4 carbon atoms, or a vinyl group, X represents a halogen atom, m is an integer from 0 to 2, and n is an integer from 0 to 2.

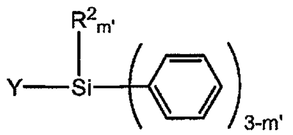

(6)

wherein $R^2$ individually represents a hydrogen atom, an alkyl group having 1 to 4 carbon atoms, or a vinyl group, Y represents a halogen atom, a hydrogen atom, or an alkoxy group, and m' is an integer from 0 to 2.

Examples of the alkyl group having 1 to 4 carbon atoms represented by $R^1$ and $R^2$ in the general formulas (5) and (6) include the alkyl groups having 1 to 4 carbon atoms mentioned in connection with $R^1$ and $R^2$ in the general formula (5). Examples of the halogen atom represented by X and Y include a bromine atom and a chlorine atom. Examples of the alkoxy group represented by Y include the alkoxy groups shown by $-OR^4$ in the general formula (5).

Examples of the alkyl group of the trialkyl orthoformate include the alkyl groups having 1 to 4 carbon atoms mentioned in connection with $R^2$ or $R^4$ in the general formula (5). Examples of the trialkyl orthoformate include trimethyl orthoformate, triethyl orthoformate, and the like. A compound that includes two or more alkoxy groups (e.g., acetone dimethyl acetal) may be used instead of the trialkyl orthoformate.

1.3.2. Second method

The second method includes allowing an organosilane compound shown by the following general formula (7) and an organosilane compound shown by the following general formula (8) to undergo a coupling reaction in the presence of a metal, and directly reacting an alcohol with the resulting product to convert the halogen atom into an alkoxy group.

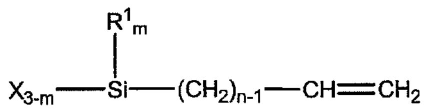

(7)

wherein $R^1$ individually represents a hydrogen atom, an alkyl group having 1 to 4 carbon atoms, or a phenyl group, X represents a halogen atom, m is an integer from 0 to 2, and n is 1 or 2.

$$Y_{3-m'}\text{-Si-}R^2_{m'} \qquad (8)$$

wherein $R^2$ individually represents a hydrogen atom, an alkyl group having 1 to 4 carbon atoms, or a phenyl group, Y represents a halogen atom, a hydrogen atom, or an alkoxy group, and m' is an integer from 0 to 2, provided that at least one of Y and $R^2$ represents a hydrogen atom.

Examples of the alkyl group having 1 to 4 carbon atoms represented by $R^1$ and $R^2$ in the general formulas (7) and (8) include the alkyl groups having 1 to 4 carbon atoms mentioned in connection with $R^1$ and $R^2$ in the general formula (1). Examples of the halogen atom represented by X and Y include a bromine atom and a chlorine atom.

Examples of the metal that may be used in the second method include platinum compounds (e.g., hexachloroplatinic acid) and rhodium compounds. Examples of the alcohol that may be used in the second method include alcohols that include an alkyl group having 1 to 4 carbon atoms.

2. Method of producing silicon-containing insulating film

A method of producing a silicon-containing insulating film according to one embodiment of the invention is preferably performed by chemical vapor deposition (CVD), and particularly preferably plasma-enhanced CVD (PECVD). Specifically, the compound 1 is vaporized in a PECVD apparatus using a vaporizer optionally together with at least one compound selected from the compounds 2 to 4 and the pore-forming agent, and introduced into a deposition chamber. Plasma is generated by applying a voltage between electrodes provided in the deposition chamber from a high-frequency power supply to form a plasma CVD film on a substrate disposed in the deposition chamber.

Examples of the substrate on which the silicon-containing insulating film is formed include Si-containing layers formed of Si, $SiO_2$, SiN, SiC, SiCN, or the like. A gas (e.g., argon or helium) and an oxidizing agent (e.g., oxygen or nitrous oxide) may be introduced into the deposition chamber in order to generate plasma. A thin film (deposited film) that is suitable as a low-dielectric-constant material for semiconductor devices can be formed by depositing the chemical vapor deposition material according to one embodiment of the invention utilizing the PECVD apparatus.

A plasma generation method using the PECVD apparatus is not particularly limited. For example, inductively-coupled plasma, capacitively-coupled plasma, ECR plasma, or the like may be used.

It is preferable that the silicon-containing deposited film thus obtained have a thickness of 0.05 to 5.0 micrometers. The deposited film is then cured to form a silicon-containing insulating film.

The deposited film may be cured by at least one means selected from heating, electron beam irradiation, ultraviolet irradiation, and oxygen plasma irradiation. The deposited film may be cured by simultaneously performing a plurality of means among these means.

When curing the deposited film by heating, the deposited film formed by CVD is heated to 80 to 450°C in an inert atmosphere or under reduced pressure, for example. The deposited film may be heated using a hot plate, an oven, a furnace, or the like. The heating atmosphere may be an inert atmosphere or an atmosphere under reduced pressure.

The mechanical strength of the resulting silicon-containing insulating film may be improved by performing at least one means selected from electron beam irradiation, ultraviolet irradiation, and oxygen plasma irradiation together with heating. In this case, it is preferable to use ultraviolet rays having a wavelength of 250 nm or less, and more preferably 200 nm or less, in order to improve the mechanical strength of the resulting silicon-containing insulating film.

In order to control the curing speed of the deposited film, the deposited film may be heated stepwise, or the atmosphere may be selected from nitrogen, air, oxygen, and an atmosphere under reduced pressure, if necessary. A silicon-containing insulating film can thus be formed.

3. Pore-forming agent

The pore-forming agent used in the method of producing a silicon-containing insulating film is described below. Examples of the pore-forming agent include compounds having a ring structure. The pore-forming agent is preferably a compound (polycyclic compound) that includes two or more rings in the molecule, and more preferably a compound that includes a condensed ring. Examples of such a compound include polycyclic hydrocarbons, monocyclic hydrocarbons, and compounds that include a heteroatom (oxygen atom, nitrogen atom, or fluorine atom (preferably an oxygen atom)).

The size and the number of pores formed in the insulating film are important to obtain an insulating film that has a low relative dielectric constant and sufficient mechanical strength. The type of pore-forming agent is one of the factors that determine the size of the pores.

The pore-forming agent is preferably a polycyclic compound in order to obtain an insulating film that has a low relative dielectric constant and sufficient mechanical strength. The polycyclic compound may be a three-membered ring compound, a four-membered ring compound, and/or a compound that has a seven- or higher membered ring structure. Examples of such a polycyclic compound include oxabicyclo compounds (e.g., cyclopentene oxide) and bicycloheptadiene (BCHD).

When the chemical vapor deposition material (composition) according to one embodiment of the invention includes the pore-forming agent, the content of the pore-forming agent is preferably 0.05 to 10,000 parts by weight, and more preferably 0.1 to 5000 parts by weight, based on 100 parts by weight of the organosilane compound. If the content of the pore-forming agent in the chemical vapor deposition material (composition) according to one embodiment of the invention is less than 0.05 parts by weight based on 100 parts by weight of the organosilane compound, it may be difficult to decrease the relative dielectric constant. If the content of the pore-forming agent is more than 10,000 parts by weight, a uniform film may not be obtained.

3.1. Oxabicyclo compound

Examples of the oxabicyclo compound include 6-oxabicyclo[3.1.0]hexane (cyclopentene oxide), 7-oxabicyclo[4.1.0]heptane (cyclohexene oxide), 9-oxabicyclo[6.1.0]nonane (cyclooctene oxide), and 7-oxabicyclo[2.2.1]heptane (1,4-epoxycyclohexane).

Further examples of the oxabicyclo compound include 9-oxabicyclo[6.1.0]non-4-ene compounds. The oxabicyclo compound may include an additional functional group (e.g., ketone, aldehyde, amine, amide, imide, ether, ester, anhydride, carbonate, thiol, or thioether) such as in 7-oxabicyclo[4.1.0]heptan-2-one and 3-oxabicyclo[3.1.0]hexane-2,4-dione.

3.2. Polycyclic hydrocarbon

The number of carbon atoms of the polycyclic hydrocarbon is preferably 6 to 12. Examples of such a polycyclic hydrocarbon include 2,5-norbornadiene (bicyclo[2.2.1]hepta-2,5-diene), norbornene, 2,5-norbornadiene (bicycle[2.2.1] hepta-2,5-diene), norbornane (bicycle[2.2.1]heptane), tricyclo[3.2.1.0]octane, tricyclo[3.2.2.0]nonane, spiro[3.4]octane, spiro[4.5]nonane, and spiro[5.6]decane.

3.3. Monocyclic hydrocarbon

Examples of the monocyclic hydrocarbon include alicyclic hydrocarbons having 5 to 12 carbon atoms such as cyclopentane and cyclohexane, and aromatic hydrocarbons having 6 to 12 carbon atoms such as benzene, toluene, and xylene (o-xylene, m-xylene, and n-xylene).

4. Silicon-containing insulating film

A silicon-containing insulating film according to one embodiment of the invention may be produced by the above method.

Since the silicon-containing insulating film according to one embodiment of the invention has a low dielectric constant and excellent surface flatness, the silicon-containing insulating film is particularly useful as an interlayer dielectric for semiconductor devices (e.g., LSI, system LSI, DRAM, SDRAM, RDRAM, and D-RDRAM). The silicon-containing insulating film may also be suitably used as an etching stopper film, a protective film (e.g., surface coating film) for semiconductor devices, an intermediate layer used in a semiconductor production process that utilizes a multilayer resist, an interlayer dielectric for multilayered wiring boards, a protective film and an insulating film for liquid crystal display devices, and the like. The silicon-containing insulating film according to one embodiment of the invention is also suitable for semiconductor devices that are formed using a copper damascene process, for example.

Since the silicon-containing insulating film according to one embodiment of the invention is formed using the above chemical vapor deposition material, the silicon-containing insulating film includes an $-Si-(CH_2)_n-Si-O-$ site (wherein n is an integer from 1 to 3). Since the silicon-containing insulating film that includes the $-Si-(CH_2)_n-Si-O-$ site has excellent chemical resistance and suppresses an increase in relative dielectric constant during processing, the silicon-containing insulating film has a low relative dielectric constant and excellent process resistance.

The silicon-containing insulating film according to one embodiment of the invention preferably has a relative dielectric constant of 3.0 or less, more preferably 1.8 to 3.0, and still more preferably 2.2 to 3.0.

The silicon-containing insulating film according to one embodiment of the invention preferably has a modulus of elasticity of 4.0 to 18.0 GPa, more preferably 4.0 to 15.0 GPa, and more preferably 10.0 to 12.0 GPa, and preferably has a hardness of 0.1 GPa or more, and more preferably 1.0 GPa or more. Therefore, the silicon-containing insulating film according to one embodiment of the invention has excellent insulating film properties (e.g., mechanical strength and relative dielectric constant).

5. Examples

The invention is further described below by way of examples. Note that the invention is not limited to the following examples. In the examples and comparative examples, the units "parts" and "%" respectively refer to "parts by weight" and "wt%" unless otherwise indicated.

5.1. Evaluation method

The properties were evaluated as follows.

5.1.1. Impurity content in organosilane compound

The water content and the impurity content of the purified organosilane compound were measured using a Karl

Fisher aquacounter ("AQ-7" manufactured by Hiranuma Sangyo Co., Ltd.) and an atomic absorption spectrophotometer (polarized Zeeman atomic absorption spectrophotometer "Z-5700" manufactured by Hitachi High-Technologies Corporation).

5.1.2. Relative dielectric constant

A silicon-containing insulating film was formed on an 8-inch silicon wafer by PECVD under conditions described later. An aluminum electrode pattern was formed on the resulting film by a deposition method to prepare a relative dielectric constant measurement sample. The relative dielectric constant of the sample (insulating film) was measured by a CV method at a frequency of 100 kHz using an electrode "HP16451B" and a precision LCR meter "HP4284A" (manufactured by Yokogawa Hewlett-Packard). The difference between the relative dielectric constant (k@RT) measured at a temperature of 24°C and a relative humidity of 40%RH and the relative dielectric constant (k@200°C) measured at a temperature of 200°C in a dry nitrogen atmosphere is referred to as $\Delta k$ ($\Delta k$=k@RT-k@200°C). An increase in relative dielectric constant due to moisture absorption of the film can be evaluated based on the value $\Delta k$. An organic silica film having a value $\Delta k$ of 0.15 or more is normally considered to have high moisture absorption properties.

5.1.3. Hardness and modulus of elasticity (Young’s modulus) of insulating film

A Berkovich indenter was installed in a nanohardness tester ("Nanoindenter XP" manufactured by MTS), and the universal hardness of the insulating film was measured. The modulus of elasticity was measured using a continuous stiffness measurement method.

5.1.4. Chemical resistance

An 8-inch wafer on which a silicon-containing insulating film was formed was immersed in a 0.2% diluted hydrofluoric acid aqueous solution at room temperature for three minutes. A change in thickness of the silicon-containing insulating film due to immersion was measured. The chemical resistance of the silicon-containing insulating film was evaluated as good when the film residual ratio defined below was 99% or more.

$$\text{Film residual ratio (\%)}$$
$$= (\text{thickness after immersion}) \div (\text{thickness before immersion}) \times 100$$

A: The film residual ratio was 99% or more.
B: The film residual ratio was 90% or more and less than 99%.
C: The film residual ratio was 70% or more and less than 90%.
D: The film residual ratio was less than 70%.

5.1.5. Plasma ashing resistance

An 8-inch wafer on which a silicon-containing insulating film was formed was exposed to organic photoresist ashing conditions utilizing nitrogen and hydrogen using a plasma ashing apparatus (manufactured by Tokyo Electron Ltd.). The plasma ashing resistance of the insulating film was evaluated from a change in dielectric constant of the insulating film due to exposure. The plasma ashing resistance was evaluated as follows.

S: An increase in relative dielectric constant was less than 0.1.
A: An increase in relative dielectric constant was 0.1 or more and less than 0.2.
B: An increase in relative dielectric constant was 0.2 or more and less than 0.5.
C: An increase in relative dielectric constant was 0.5 or more.

5.2. Chemical vapor deposition material production example

5.2.1. Synthesis Example 1

A three-necked flask equipped with a cooling condenser and a dropping funnel was dried at 50°C under reduced pressure, and charged with nitrogen. After the addition of 30 g of magnesium and 500 ml of THF to the flask, 25 g of

(chloromethyl)methyldiphenylsilane was added to the mixture at room temperature with stirring. After continuously stirring the mixture and confirming generation of heat, 222 g of (chloromethyl)methyldiphenylsilane was added dropwise to the mixture from the dropping funnel over one hour. After the addition, the mixture was allowed to cool to room temperature. A mixture of 250 ml of THF and 233 g of methyldiphenylchlorosilane was added to the flask, and the mixture was refluxed with heating at 70°C for six hours to complete the reaction. After cooling the mixture to room temperature, the reaction was inactivated by adding a 3% ammonium chloride aqueous solution. After the addition of 500 ml of diethyl ether, the organic phase was washed twice with 1 l of a 3% sodium chloride aqueous solution. The organic phase was dried over magnesium sulfate, and concentrated under reduced pressure to obtain a crude product. The crude product was separated by silica gel chromatography to obtain 334 g (yield: 82%) of bis(diphenylmethylsilyl)methane.

A three-necked flask equipped with a gas tube and a drying tube was charged with 204 g of bis(diphenylmethylsilyl)methane, 500 ml of benzene, and 1.5 g of aluminum chloride. Dry hydrogen chloride gas was introduced into the flask for three hours while stirring the mixture at room temperature. After the addition of 5 ml of acetone, salts were filtered out. The mixture was concentrated under reduced pressure to remove the solvent. The resulting crude product was separated by distillation to obtain 91 g (yield: 75%) of bis(dichloromethylsilyl)methane.

A three-necked flask equipped with a cooling condenser and a dropping funnel was charged with 85 g of bis (dichloromethylsilyl)methane. 149 g of trimethyl orthoformate was added dropwise to the flask from the dropping funnel at room temperature over one hour. After the addition, the mixture was stirred at room temperature for two days, followed by distillation to obtain 72 g (yield: 86%) of bis(dimethoxymethylsilyl)methane. The purity of the resulting compound determined by GC was 99.3%. The residual water content in the compound was 117 ppm. The content (metal impurity content) of elements other than silicon, carbon, oxygen, and hydrogen in the compound was as follows. Specifically, the Na content was 1.0 ppb, the K content was 1.2 ppb, and the Fe content was 1.3 ppb. The content of each of Li, Mg, Cr, Ag, Cu, Zn, Mn, Co, Ni, Ti, Zr, Al, Pb, Sn, and W was equal to or less than the detection limit (0.2 ppb). It was thus confirmed that the organosilane compound obtained by Synthesis Example 1 had a purity sufficient for an insulating film-forming material.

### 5.2.2. Synthesis Example 2

A three-necked flask equipped with a cooling condenser and a dropping funnel was dried at 50°C under reduced pressure, and charged with nitrogen. After the addition of 30 g of magnesium and 500 ml of THF to the flask, 25 g of (chloromethyl)methyldiphenylsilane was added to the mixture at room temperature with stirring. After continuously stirring the mixture and confirming generation of heat, 222 g of (chloromethyl)methyldiphenylsilane was added dropwise to the mixture from the dropping funnel over one hour. After the addition, the mixture was allowed to cool to room temperature. A mixture of 250 ml of THF and 219 g of diphenylchlorosilane was added to the flask, and the mixture was refluxed with heating at 70°C for six hours to complete the reaction. After cooling the mixture to room temperature, the reaction was inactivated by adding a 3% ammonium chloride aqueous solution. After the addition of 500 ml of diethyl ether, the organic phase was washed twice with 1 1 of a 3% sodium chloride aqueous solution. The organic phase was dried over magnesium sulfate, and concentrated under reduced pressure to obtain a crude product. The crude product was separated by silica gel chromatography to obtain 324 g (yield: 82%) of 1,1,3,3-tetraphenyl-1,3-disilabutane.

A three-necked flask equipped with a gas tube and a drying tube was charged with 198 g of 1,1,3,3-tetraphenyl-1,3-disilabutane, 500 ml of benzene, and 1.5 g of aluminum chloride. Dry hydrogen chloride gas was introduced into the flask for three hours while stirring the mixture at room temperature. After the addition of 5 ml of acetone, salts were filtered out. The mixture was concentrated under reduced pressure to remove the solvent. The resulting crude product was separated by distillation to obtain 86 g (yield: 75%) of 1, 1,3,3-tetrachloro-1,3-disilabutane.

A three-necked flask equipped with a cooling condenser and a dropping funnel was charged with 86 g of 1,1,3,3-tetrachloro-1,3-disilabutane. 149 g of trimethyl orthoformate was added dropwise to the flask from the dropping funnel at room temperature over one hour. After the addition, the mixture was stirred at room temperature for two days, followed by distillation to obtain 67 g (yield: 86%) of 1,1,3,3-tetramethoxy-1,3-disilabutane. The purity of the resulting compound determined by GC was 99.3%. The residual water content in the compound was 131 ppm. The content (metal impurity content) of elements other than silicon, carbon, oxygen, and hydrogen in the compound was as follows. Specifically, the Na content was 1.4 ppb, the K content was 1.1 ppb, and the Fe content was 1.5 ppb. The content of each of Li, Mg, Cr, Ag, Cu, Zn, Mn, Co, Ni, Ti, Zr, Al, Pb, Sn, and W was equal to or less than the detection limit (0.2 ppb). It was thus confirmed that the organosilane compound obtained by Synthesis Example 2 had a purity sufficient for an insulating film-forming material.

### 5.2.3. Synthesis Example 3

A three-necked flask equipped with a cooling condenser and a dropping funnel was dried at 50°C under reduced pressure, and charged with nitrogen. After the addition of 214 g of bis(dichlorosilyl)methane and 500 ml of THF to the

flask, 424 g of trimethyl orthoformate was added dropwise to the mixture from the dropping funnel at room temperature over two hours with stirring. After the addition, the mixture was stirred at room temperature for two days, followed by distillation to obtain 169 g (yield: 85%) of bis(dimethoxy silyl)methane. The purity of the resulting compound determined by GC was 99.1%. The residual water content in the compound was 176 ppm. The content (metal impurity content) of elements other than silicon, carbon, oxygen, and hydrogen in the compound was as follows. Specifically, the Na content was 1.2 ppb, the K content was 1.6 ppb, and the Fe content was 1.9 ppb. The content of each of Li, Mg, Cr, Ag, Cu, Zn, Mn, Co, Ni, Ti, Zr, Al, Pb, Sn, and W was equal to or less than the detection limit (0.2 ppb). It was thus confirmed that the organosilane compound obtained by Synthesis Example 3 had a purity sufficient for an insulating film-forming material.

5.2.4. Synthesis Example 4

A three-necked flask equipped with a cooling condenser and a dropping funnel was dried at 50°C under reduced pressure, and charged with nitrogen. After the addition of 30 g of magnesium and 500 ml of THF to the flask, 25 g of (chloromethyl)methyldiphenylsilane was added to the mixture at room temperature with stirring. After continuously stirring the mixture and confirming generation of heat, 222 g of (chloromethyl)methyldiphenylsilane was added dropwise to the mixture from the dropping funnel over one hour. After the addition, the mixture was allowed to cool to room temperature. A mixture of 250 ml of THF and 320 g of triphenylchlorosilane was added to the flask, and the mixture was refluxed with heating at 70°C for six hours to complete the reaction. After cooling the mixture to room temperature, the reaction was inactivated by adding a 3% ammonium chloride aqueous solution. After the addition of 500 ml of diethyl ether, the organic phase was washed twice with 1 1 of a 3% sodium chloride aqueous solution. The organic phase was dried over magnesium sulfate, and concentrated under reduced pressure to obtain a crude product. The crude product was separated by silica gel chromatography to obtain 410 g (yield: 87%) of 1,1,1,3,3-pentaphenyl-1,3-disilabutane.

A three-necked flask equipped with a gas tube and a drying tube was charged with 235 g of 1,1,1,3,3-pentaphenyl-1,3-disilabutane, 500 ml of benzene, and 1.5 g of aluminum chloride. Dry hydrogen chloride gas was introduced into the flask for three hours while stirring the mixture at room temperature. After the addition of 5 ml of acetone, salts were filtered out. The mixture was concentrated under reduced pressure to remove the solvent. The resulting crude product was separated by distillation to obtain 105 g (yield: 80%) of 1,1,1,3,3-pentachloro-1,3-disilabutane.

A three-necked flask equipped with a cooling condenser and a dropping funnel was charged with 105 g of 1,1,1,3,3-pentachloro-1,3-disilabutane. 170 g of trimethyl orthoformate was added dropwise to the flask from the dropping funnel at room temperature over one hour. After the addition, the mixture was stirred at room temperature for two days, followed by distillation to obtain 70 g (yield: 73%) of 1,1,1,3,3-pentamethoxy-1,3-disilabutane. The purity of the resulting compound determined by GC was 99.3%. The residual water content in the compound was 129 ppm. The content (metal impurity content) of elements other than silicon, carbon, oxygen, and hydrogen in the compound was as follows. Specifically, the Na content was 1.2 ppb, the K content was 1.3 ppb, and the Fe content was 1.1 ppb. The content of each of Li, Mg, Cr, Ag, Cu, Zn, Mn, Co, Ni, Ti, Zr, Al, Pb, Sn, and W was equal to or less than the detection limit (0.2 ppb). It was thus confirmed that the organosilane compound obtained by Synthesis Example 4 had a purity sufficient for an insulating film-forming material.

5.2.5. Synthesis Example 5

A three-necked flask equipped with a cooling condenser and a dropping funnel was dried at 50°C under reduced pressure, and charged with nitrogen. After the addition of 30 g of magnesium and 500 ml of THF to the flask, 25 g of

(chloromethyl)dimethylphenylsilane was added to the mixture at room temperature with stirring. After continuously stirring the mixture and confirming generation of heat, 160 g of (chloromethyl)dimethylphenylmethylsilane was added to the mixture from the dropping funnel over one hour. After the addition, the mixture was allowed to cool to room temperature. A mixture of 250 ml of THF and 233 g of methyldiphenylchlorosilane was added to the flask, and the mixture was refluxed with heating at 70°C for six hours to complete the reaction. After cooling the mixture to room temperature, the reaction was inactivated by adding a 3% ammonium chloride aqueous solution. After the addition of 500 ml of diethyl ether, the organic phase was washed twice with 1 1 of a 3% sodium chloride aqueous solution. The organic phase was dried over magnesium sulfate, and concentrated under reduced pressure to obtain a crude product. The crude product was separated by silica gel chromatography to obtain 304 g (yield: 88%) of 2-methyl-2,4,4-triphenyl-2,4-disilapentane.

A three-necked flask equipped with a gas tube and a drying tube was charged with 173 g of 2-methyl-2,4,4-triphenyl-2,4-disilapentane, 500 ml of benzene, and 1.5 g of aluminum chloride. Dry hydrogen chloride gas was introduced into the flask for three hours while stirring the mixture at room temperature. After the addition of 5 ml of acetone, salts were filtered out. The mixture was concentrated under reduced pressure to remove the solvent. The resulting crude product was separated by distillation to obtain 78 g (yield: 70%) of 2,2,4-trichloro-4-methyl-2,4-disilapentane.

A three-necked flask equipped with a cooling condenser and a dropping funnel was charged with 78 g of 2,2,4-trichloro-4-methyl-2,4-disilapentane. 149 g of trimethyl orthoformate was added dropwise to the flask from the dropping

funnel at room temperature over one hour. After the addition, the mixture was stirred at room temperature for two days, followed by distillation to obtain 62 g (yield: 86%) of 2,2,4-trimethoxy-4-methyl-2,4-disilapentane. The purity of the resulting compound determined by GC was 99.1%. The residual water content in the compound was 127 ppm. The content (metal impurity content) of elements other than silicon, carbon, oxygen, and hydrogen in the compound was as follows. Specifically, the Na content was 1.1 ppb, the K content was 1.0 ppb, and the Fe content was 1.3 ppb. The content of each of Li, Mg, Cr, Ag, Cu, Zn, Mn, Co, Ni, Ti, Zr, Al, Pb, Sn, and W was equal to or less than the detection limit (0.2 ppb). It was thus confirmed that the organosilane compound obtained by Synthesis Example 5 had a purity sufficient for an insulating film-forming material.

5.2.6. Synthesis Example 6

A three-necked flask equipped with a cooling condenser and a dropping funnel was dried at 50°C under reduced pressure, and charged with nitrogen. After the addition of 30 g of magnesium and 500 ml of THF to the flask, 25 g of (chloromethyl)diphenylvinylsilane was added to the mixture at room temperature with stirring. After continuously stirring the mixture and confirming generation of heat, 234 g of (chloromethyl)diphenylvinylsilane was added dropwise to the mixture from the dropping funnel over one hour. After the addition, the mixture was allowed to cool to room temperature. A mixture of 250 ml of THF and 250 g of diphenylvinylchlorosilane was added to the flask, and the mixture was refluxed with heating at 70°C for six hours to complete the reaction. After cooling the mixture to room temperature, the reaction was inactivated by adding a 3% ammonium chloride aqueous solution. After the addition of 500 ml of diethyl ether, the organic phase was washed twice with 1 1 of a 3% sodium chloride aqueous solution. The organic phase was dried over magnesium sulfate, and concentrated under reduced pressure to obtain a crude product. The crude product was separated by silica gel chromatography to obtain 281 g (yield: 65%) of bis(diphenylvinylsilyl)methane.

A three-necked flask equipped with a gas tube and a drying tube was charged with 216 g of bis(diphenylvinylsilyl)methane, 500 ml of benzene, and 1.5 g of aluminum chloride. Dry hydrogen chloride gas was introduced into the flask for three hours while stirring the mixture at room temperature. After the addition of 5 ml of acetone, salts were filtered out. The mixture was concentrated under reduced pressure to remove the solvent. The resulting crude product was separated by distillation to obtain 106 g (yield: 80%) of bis(dichlorovinylsilyl)methane.

A three-necked flask equipped with a cooling condenser and a dropping funnel was charged with 93 g of bis(dichlorovinylsilyl)methane. 149 g of trimethyl orthoformate was added dropwise to the flask from the dropping funnel at room temperature over one hour. After the addition, the mixture was stirred at room temperature for two days, followed by distillation to obtain 55 g (yield: 63%) of bis(dimethoxyvinylsilyl)methane. The purity of the resulting compound determined by GC was 99.2%. The residual water content in the compound was 107 ppm. The content (metal impurity content) of elements other than silicon, carbon, oxygen, and hydrogen in the compound was as follows. Specifically, the Na content was 0.8 ppb, the K content was 1.1 ppb, and the Fe content was 1.7 ppb. The content of each of Li, Mg, Cr, Ag, Cu, Zn, Mn, Co, Ni, Ti, Zr, Al, Pb, Sn, and W was equal to or less than the detection limit (0.2 ppb). It was thus confirmed that the organosilane compound obtained by Synthesis Example 6 had a purity sufficient for an insulating film-forming material.

5.2.7. Synthesis Example 7

A three-necked flask equipped with a cooling condenser and a dropping funnel was dried at 50°C under reduced pressure, and charged with nitrogen. After the addition of 30 g of magnesium and 500 ml of THF to the flask, 25 g of (chloromethyl)vinyldiphenylsilane was added to the mixture at room temperature with stirring. After continuously stirring the mixture and confirming generation of heat, 234 g of (chloromethyl)vinyldiphenylsilane was added dropwise to the mixture from the dropping funnel over one hour. After the addition, the mixture was allowed to cool to room temperature. A mixture of 250 ml of THF and 320 g of triphenylchlorosilane was added to the flask, and the mixture was refluxed with heating at 70°C for six hours to complete the reaction. After cooling the mixture to room temperature, the reaction was inactivated by adding a 3% ammonium chloride aqueous solution. After the addition of 500 ml of diethyl ether, the organic phase was washed twice with 1 1 of a 3% sodium chloride aqueous solution. The organic phase was dried over magnesium sulfate, and concentrated under reduced pressure to obtain a crude product. The crude product was separated by silica gel chromatography to obtain 367 g (yield: 76%) of 1,1,1,3,3-pentaphenyl-3-vinyl-1,3-disilapropane.

A three-necked flask equipped with a gas tube and a drying tube was charged with 241 g of 1,1,1,3,3-pentaphenyl-3-vinyl-1,3-disilapropane, 500 ml of benzene, and 1.5 g of aluminum chloride. Dry hydrogen chloride gas was introduced into the flask for three hours while stirring the mixture at room temperature. After the addition of 5 ml of acetone, salts were filtered out. The mixture was concentrated under reduced pressure to remove the solvent. The resulting crude product was separated by distillation to obtain 103 g (yield: 75%) of

1,1,1,3,3-pentachloro-3-vinyl-1,3-disilapropane.

A three-necked flask equipped with a cooling condenser and a dropping funnel was charged with 103 g of 1,1,1,3,3-pentachloro-3-vinyl-1,3-disilapropane. 148 g of trimethyl orthoformate was added dropwise to the flask from the dropping funnel at room temperature over one hour. After the addition, the mixture was stirred at room temperature for two days, followed by distillation to obtain 79 g (yield: 89%) of 1,1,1,3,3-pentamethoxy-3-vinyl-1,3-disilapropane. The purity of the resulting compound determined by GC was 98.6%. The residual water content in the compound was 162 ppm. The content (metal impurity content) of elements other than silicon, carbon, oxygen, and hydrogen in the compound was as follows. Specifically, the Na content was 1.2 ppb, the K content was 1.1 ppb, and the Fe content was 1.0 ppb. The content of each of Li, Mg, Cr, Ag, Cu, Zn, Mn, Co, Ni, Ti, Zr, Al, Pb, Sn, and W was equal to or less than the detection limit (0.2 ppb). It was thus confirmed that the organosilane compound obtained by Synthesis Example 7 had a purity sufficient for an insulating film-forming material.

5.2.8. Synthesis Example 8

A three-necked flask equipped with a cooling condenser and a dropping funnel was dried at 50°C under reduced pressure, and charged with nitrogen. After the addition of 30 g of magnesium and 500 ml of THF to the flask, 25 g of (chloromethyl)divinylphenylsilane was added to the mixture at room temperature with stirring. After continuously stirring the mixture and confirming generation of heat, 184 g of (chloromethyl)divinylphenylmethylsilane was added dropwise to the mixture from the dropping funnel over one hour. After the addition, the mixture was allowed to cool to room temperature. A mixture of 250 ml of THF and 320 g of triphenylchlorosilane was added to the flask, and the mixture was refluxed with heating at 70°C for six hours to complete the reaction. After cooling the mixture to room temperature, the reaction was inactivated by adding a 3% ammonium chloride aqueous solution. After the addition of 500 ml of diethyl ether, the organic phase was washed twice with 1 1 of a 3% sodium chloride aqueous solution. The organic phase was dried over magnesium sulfate, and concentrated under reduced pressure to obtain a crude product. The crude product was separated by silica gel chromatography to obtain 260 g (yield: 60%) of 1,1,1,3-tetraphenyl-3,3-divinyl-1,3-disilapropane.

A three-necked flask equipped with a gas tube and a drying tube was charged with 216 g of 1,1,1,3-tetraphenyl-3,3-divinyl-1,3-disilapropane, 500 ml of benzene, and 1.5 g of aluminum chloride. Dry hydrogen chloride gas was introduced into the flask for three hours while stirring the mixture at room temperature. After the addition of 5 ml of acetone, salts were filtered out. The mixture was concentrated under reduced pressure to remove the solvent. The resulting crude product was separated by distillation to obtain 100 g (yield: 75%) of

1,1,1,3-tetrachloro-3,3-divinyl-1,3-disilapropane.

A three-necked flask equipped with a cooling condenser and a dropping funnel was charged with 100 g of 1,1,1,3-tetrachloro-3,3-divinyl-1,3-disilapropane. 159 g of trimethyl orthoformate was added dropwise to the flask from the dropping funnel at room temperature over one hour. After the addition, the mixture was stirred at room temperature for two days, followed by distillation to obtain 63 g (yield: 68%) of 1,1,1,3-tetramethoxy-3,3-divinyl-1,3-disilapropane. The purity of the resulting compound determined by GC was 98.9%. The residual water content in the compound was 112 ppm. The content (metal impurity content) of elements other than silicon, carbon, oxygen, and hydrogen in the compound was as follows. Specifically, the Na content was 1.0 ppb, the K content was 1.9 ppb, and the Fe content was 2.0 ppb. The content of each of Li, Mg, Cr, Ag, Cu, Zn, Mn, Co, Ni, Ti, Zr, Al, Pb, Sn, and W was equal to or less than the detection limit (0.2 ppb). It was thus confirmed that the organosilane compound obtained by Synthesis Example 8 had a purity sufficient for an insulating film-forming material.

5.2.9. Synthesis Example 9

A three-necked flask equipped with a cooling condenser and a dropping funnel was dried at 50°C under reduced pressure, and charged with nitrogen. After the addition of 500 ml of toluene to the flask, 129 g of ethyldichlorosilane and 155 g of vinylethyldichlorosilane were added to the flask at room temperature with stirring. After continuously stirring the mixture, 100 mg of chloroplatinic acid was added to the mixture. The mixture was then allowed to react at 100°C for five hours. After cooling the mixture to room temperature, 238 g of pyridine was added to the mixture. 140 g of ethanol was then added dropwise to the mixture with stirring. After the addition, the mixture was allowed to react at room temperature for three hours. Salts produced were filtered out, and the filtrate was fractionated to obtain 232 g (yield: 72%) of 1,2-bis (diethoxyethylsilyl)ethane. The purity of the resulting compound determined by GC was 99.4%. The residual water content in the compound was 41 ppm. The content (metal impurity content) of elements other than silicon, carbon, oxygen, and hydrogen in the compound was as follows. Specifically, the Na content was 1.1 ppb, the K content was 1.5

ppb, and the Fe content was 1.8 ppb. The content of each of Li, Mg, Cr, Ag, Cu, Zn, Mn, Co, Ni, Ti, Zr, Al, Pb, Sn, W, and Pt was equal to or less than the detection limit (0.2 ppb). It was thus confirmed that the organosilane compound obtained by Synthesis Example 9 had a purity sufficient for an insulating film-forming material.

5.2.10. Synthesis Example 10

A three-necked flask equipped with a cooling condenser and a dropping funnel was dried at 50°C under reduced pressure, and charged with nitrogen. After the addition of 500 ml of toluene to the flask, 135 g of trichlorosilane and 174 g of ethylvinyldiethoxysilane were added to the flask at room temperature with stirring. After continuously stirring the mixture, 100 mg of chloroplatinic acid was added to the mixture. The mixture was then allowed to react at 100°C for five hours. After cooling the mixture to room temperature, 158 g of pyridine was added to the mixture. 138 g of ethanol was then added dropwise to the mixture with stirring. After the addition, the mixture was allowed to react at room temperature for three hours. Salts produced were filtered out, and the filtrate was fractionated to obtain 220 g (yield: 65%) of 1,1,1,4,4-pentaethoxy-1,4-disilahexane. The purity of the resulting compound determined by GC was 99.0%. The residual water content in the compound was 185 ppm. The content (metal impurity content) of elements other than silicon, carbon, oxygen, and hydrogen in the compound was as follows. Specifically, the Na content was 1.2 ppb, the K content was 1.1 ppb, and the Fe content was 1.7 ppb. The content of each of Li, Mg, Cr, Ag, Cu, Zn, Mn, Co, Ni, Ti, Zr, Al, Pb, Sn, W, Pt was equal to or less than the detection limit (0.2 ppb). It was thus confirmed that the organosilane compound obtained by Synthesis Example 10 had a purity sufficient for an insulating film-forming material.

5.2.11. Synthesis Example 11

A three-necked flask equipped with a cooling condenser and a dropping funnel was dried at 50°C under reduced pressure, and charged with nitrogen. After the addition of 500 ml of toluene to the flask, 129 g of ethyldichlorosilane and 149 g of vinyldiethylchlorosilane were added to the flask at room temperature with stirring. After continuously stirring the mixture, 100 mg of chloroplatinic acid was added to the mixture. The mixture was then allowed to react at 100°C for five hours. After cooling the mixture to room temperature, 238 g of pyridine was added to the mixture. 140 g of ethanol was then added dropwise to the mixture with stirring. After the addition, the mixture was allowed to react at room temperature for three hours. Salts produced were filtered out, and the filtrate was fractionated to obtain 215 g (yield: 70%) of 3,3,6-triethoxy-6-ethyl-3,6-disilaoctane. The purity of the resulting compound determined by GC was 99.4%. The residual water content in the compound was 45 ppm. The content (metal impurity content) of elements other than silicon, carbon, oxygen, and hydrogen in the compound was as follows. Specifically, the Na content was 1.8 ppb, the K content was 1.1 ppb, and the Fe content was 1.3 ppb. The content of each of Li, Mg, Cr, Ag, Cu, Zn, Mn, Co, Ni, Ti, Zr, Al, Pb, Sn, W, and Pt was equal to or less than the detection limit (0.2 ppb). It was thus confirmed that the organosilane compound obtained by Synthesis Example 11 had a purity sufficient for an insulating film-forming material.

5.2.12. Synthesis Example 12

A three-necked flask equipped with a cooling condenser and a dropping funnel was dried at 50°C under reduced pressure, and charged with nitrogen. After the addition of 500 ml of toluene to the flask, 135 g of trichlorosilane and 130 g of ethylvinylethoxysilane were added to the flask at room temperature with stirring. After continuously stirring the mixture, 100 mg of chloroplatinic acid was added to the mixture. The mixture was then allowed to react at 100°C for five hours. After cooling the mixture to room temperature, 158 g of pyridine was added to the mixture. 138 g of ethanol was then added dropwise to the mixture with stirring. After the addition, the mixture was allowed to react at room temperature for three hours. Salts produced were filtered out, and the filtrate was fractionated to obtain 190 g (yield: 65%) of 1,1,1,4-tetraethoxy-1,4-disilahexane. The purity of the resulting compound determined by GC was 99.0%. The residual water content in the compound was 185 ppm. The content (metal impurity content) of elements other than silicon, carbon, oxygen, and hydrogen in the compound was as follows. Specifically, the Na content was 1.2 ppb, the K content was 1.1 ppb, and the Fe content was 1.7 ppb. The content of each of Li, Mg, Cr, Ag, Cu, Zn, Mn, Co, Ni, Ti, Zr, Al, Pb, Sn, W, and Pt was equal to or less than the detection limit (0.2 ppb). It was thus confirmed that the organosilane compound obtained by Synthesis Example 12 had a purity sufficient for an insulating film-forming material.

5.2.13. Reference Synthesis Example 1

A three-necked flask equipped with a cooling condenser and a dropping funnel was dried at 50°C under reduced pressure, and charged with nitrogen. After the addition of 20 g of magnesium and 500 ml of THF to the flask, 25 g of (chloromethyl)trimethylsilane was added to the mixture at room temperature with stirring. After continuously stirring the mixture and confirming generation of heat, 55 g of (chloromethyl)trimethylsilane was added to the mixture from the

dropping funnel over 30 minutes. After the addition, the mixture was allowed to cool to room temperature. A mixture of 250 ml of THF and 237 g of methyltrimethoxysilane was added to the flask, and the mixture was refluxed with heating at 70°C for six hours to complete the reaction. After cooling the reaction solution to room temperature, magnesium salts produced and unreacted magnesium were filtered out. The filtrate was fractionated to obtain 75 g (yield: 60%) of [(trimethylsilyl)methyl]methyldimethoxysilane. The purity of the resulting compound determined by GC was 99.4%. The residual water content in the compound was 120 ppm. The content (metal impurity content) of elements other than silicon, carbon, oxygen, and hydrogen in the compound was as follows. Specifically, the Na content was 1.2 ppb, the K content was 1.5 ppb, and the Fe content was 1.1 ppb. The content of each of Li, Mg, Cr, Ag, Cu, Zn, Mn, Co, Ni, Ti, Zr, Al, Pb, Sn, W, and Pt was equal to or less than the detection limit (0.2 ppb). It was thus confirmed that the organosilane compound obtained by Reference Synthesis Example 1 had a purity sufficient for an insulating film-forming material.

5.2.14. Reference Synthesis Example 2

A three-necked flask equipped with a cooling condenser and a dropping funnel was dried at 50°C under reduced pressure, and charged with nitrogen. After the addition of 20 g of magnesium and 500 ml of THF to the flask, 25 g of (chloromethyl)methyldivinylsilane was added to the mixture at room temperature with stirring. After continuously stirring the mixture and confirming generation of heat, 48 g of (chloromethyl)methyldivinylsilane was added to the mixture from the dropping funnel over 30 minutes. After the addition, the mixture was allowed to cool to room temperature. A mixture of 250 ml of THF and 115 g of tetramethoxysilane was added to the flask, and the mixture was refluxed with heating at 70°C for six hours to complete the reaction. After cooling the reaction solution to room temperature, magnesium salts produced and unreacted magnesium were filtered out. The filtrate was fractionated to obtain 76 g (yield: 65%) of [(methyldivinylsilyl)methyl]trimethoxysilane. The purity of the resulting compound determined by GC was 99.3%. The residual water content in the compound was 116 ppm. The content (metal impurity content) of elements other than silicon, carbon, oxygen, and hydrogen in the compound was as follows. Specifically, the Na content was 1.9 ppb, the K content was 2.1 ppb, and the Fe content was 2.0 ppb. The content of each of Li, Mg, Cr, Ag, Cu, Zn, Mn, Co, Ni, Ti, Zr, Al, Pb, Sn, W, and Pt was equal to or less than the detection limit (0.2 ppb). It was thus confirmed that the organosilane compound obtained by Reference Synthesis Example 2 had a purity sufficient for an insulating film-forming material.

5.2.15. Reference Synthesis Example 3

A three-necked flask equipped with a cooling condenser and a dropping funnel was dried at 50°C under reduced pressure, and charged with nitrogen. After the addition of 500 ml of THF and 353 g of 1,2-bis(triethoxysilyl)vinylene to the flask, 2 1 of a 1 mol/l THF solution of ethylmagnesium bromide was added to the flask at room temperature with stirring. The mixture was then allowed to react at 60°C for five hours. After cooling the mixture to room temperature, salts produced were filtered out, and the filtrate was fractionated to obtain 161 g (yield: 50%) of 1,2-bis(diethoxyethylsilyl) vinylene. The purity of the resulting compound determined by GC was 98.2%. The residual water content in the compound was 88 ppm. The content (metal impurity content) of elements other than silicon, carbon, oxygen, and hydrogen in the compound was as follows. Specifically, the Na content was 1.2 ppb, the K content was 1.7 ppb, and the Fe content was 1.0 ppb. The content of each of Li, Mg, Cr, Ag, Cu, Zn, Mn, Co, Ni, Ti, Zr, Al, Pb, Sn, and W was equal to or less than the detection limit (0.2 ppb). It was thus confirmed that the organosilane compound obtained by Reference Synthesis Example 3 had a purity sufficient for an insulating film-forming material.

5.2.16. Reference Synthesis Example 4

A three-necked flask equipped with a cooling condenser and a dropping funnel was dried at 50°C under reduced pressure, and charged with nitrogen. After the addition of 500 ml of toluene to the flask, 129 g of ethyldichlorosilane and 142 g of vinyltriethylsilane were added to the flask at room temperature with stirring. After continuously stirring the mixture, 100 mg of chloroplatinic acid was added to the mixture. The mixture was then allowed to react at 100°C for five hours. After cooling the mixture to room temperature, 160 g of pyridine was added to the mixture. 100 g of ethanol was then added dropwise to the mixture with stirring. After the addition, the mixture was allowed to react at room temperature for three hours. Salts produced were filtered out, and the filtrate was fractionated to obtain 180 g (yield: 62%) of [(triethylsilyl)ethyl]ethyldiethoxysilane (compound C). The purity of the resulting compound determined by GC was 99.2%. The residual water content in the compound was 95 ppm. The content (metal impurity content) of elements other than silicon, carbon, oxygen, and hydrogen in the compound was as follows. Specifically, the Na content was 1.6 ppb, the K content was 1.1 ppb, and the Fe content was 1.8 ppb. The content of each of Li, Mg, Cr, Ag, Cu, Zn, Mn, Co, Ni, Ti, Zr, Al, Pb, Sn, and W was equal to or less than the detection limit (0.2 ppb). It was thus confirmed that the organosilane compound obtained by Reference Synthesis Example 4 had a purity sufficient for an insulating film-forming material.

5.3. Silicon-containing insulating film production example

5.3.1. Example 1

A silicon-containing insulating film (thickness: 0.5 micrometers) was deposited on a silicon substrate using a dual-frequency plasma CVD apparatus (manufactured by Youtec Co., Ltd.), bis(trimethoxysilyl)methane (gas flow rate: 0.3 sccm) as a silica source, and bicyclo[2.2.1]hepta-2,5-diene (gas flow rate: 0.6 sccm) as a pore-forming agent (Ar gas flow rate: 100 sccm, RF upper shower head power: 300 W (27.12 MHz), lower substrate power: 150 W (380 kHz), substrate temperature: 300°C, reaction pressure: 10 Torr).

5.3.2. Example 2

A silicon-containing film (thickness: 0.5 micrometers) was deposited on a silicon substrate in the same manner as in Example 1, except for using bis(dimethoxymethylsilyl)methane synthesized in Synthesis Example 1 as the silica source.

5.3.3. Example 3

A silicon-containing film (thickness: 0.5 micrometers) was deposited on a silicon substrate in the same manner as in Example 1, except for using 1,1,3,3-tetramethoxy-1,3-disilabutane synthesized in Synthesis Example 2 as the silica source and supplying $O_2$ gas at a flow rate of 1.0 sccm.

5.3.4. Example 4

A silicon-containing film (thickness: 0.5 micrometers) was deposited on a silicon substrate in the same manner as in Example 1, except for using bis(dimethoxysilyl)methane synthesized in Synthesis Example 3 as the silica source and supplying $O_2$ gas at a flow rate of 1.0 sccm.

Table 1 shows the evaluation results for the silicon-containing films obtained in Examples 1 to 6 and Comparative Examples 1 to 3.

5.3.5. Example 5

A silicon-containing insulating film (thickness: 0.5 micrometers) was deposited on a silicon substrate using a dual-frequency plasma CVD apparatus (manufactured by Youtec Co., Ltd.), 1,1,1,3,3-pentamethoxy-1,3-disilabutane synthesized in Synthesis Example 4 (gas flow rate: 0.3 sccm) as a silica source, and bicyclo[2.2.1]hepta-2,5-diene (gas flow rate: 0.6 sccm) as a pore-forming agent (Ar gas flow rate: 100 sccm, RF upper shower head power: 300 W (27.12 MHz), lower substrate power: 150 W (380 kHz), substrate temperature: 300°C, reaction pressure: 10 Torr).

5.3.6. Example 6

A silicon-containing insulating film (thickness: 0.5 micrometers) was deposited on a silicon substrate using a dual-frequency plasma CVD apparatus (manufactured by Youtec Co., Ltd.), 2,2,4-trimethoxy-4-methyl-2,4-disilapentane synthesized in Synthesis Example 5 (gas flow rate: 0.3 sccm) as a silica source, and bicyclo[2.2.1]hepta-2,5-diene (gas flow rate: 0.6 sccm) as a pore-forming agent (Ar gas flow rate: 100 sccm, RF upper shower head power: 300 W (27.12 MHz), lower substrate power: 150 W (380 kHz), substrate temperature: 300°C, reaction pressure: 10 Torr).

5.3.7. Comparative Example 1

A silicon-containing insulating film (thickness: 0.5 micrometers) was deposited on a silicon substrate in the same manner as in Example 6, except for using methyltrimethoxysilane as the silica source.

5.3.8. Comparative Example 2

A silicon-containing insulating film (thickness: 0.5 micrometers) was deposited on a silicon substrate in the same manner as in Example 6, except for using

[(trimethylsilyl)methyl]methyldimethoxysilane synthesized in Reference Synthesis Example 1 as the silica source.

5.3.9. Example 7

A silicon-containing film (thickness: 0.5 micrometers) was deposited on a silicon substrate in the same manner as in Example 1, except for using bis(dimethoxyvinylsilyl)methane synthesized in Synthesis Example 6 (gas flow rate: 0.3 sccm) as the silica source, and cyclopentene oxide (gas flow rate: 0.6 sccm) as the pore-forming agent.

5.3.10. Example 8

A silicon-containing film (thickness: 0.5 micrometers) was deposited on a silicon substrate in the same manner as in Example 5, except for using 1,1,1,3,3-pentamethoxy-3-vinyl-1,3-disilapropane synthesized in Synthesis Example 7 as the silica source, and cyclopentene oxide as the pore-forming agent (gas flow rate: 0.6 sccm).

5.3.11. Example 9

A silicon-containing film (thickness: 0.5 micrometers) was deposited on a silicon substrate in the same manner as in Example 6, except for using 1,1,1,3-tetramethoxy-3,3-divinyl-1,3-disilapropane synthesized in Synthesis Example 8 as the silica source, and cyclopentene oxide as the pore-forming agent (gas flow rate: 0.6 sccm).

5.3.12. Comparative Example 3

A silicon-containing insulating film (thickness: 0.5 micrometers) was deposited on a silicon substrate in the same manner as in Example 11, except for using vinyltrimetoxysilane as the silica source.

5.3.13. Comparative Example 4

A silicon-containing insulating film (thickness: 0.5 micrometers) was deposited on a silicon substrate in the same manner as in Example 9, except for using [(methyldivinylsilyl)methyl]trimethoxysilane synthesized in Reference Synthesis Example 2 as the silica source.

5.3.14. Example 10

A silicon-containing film (thickness: 0.5 micrometers) was deposited on a silicon substrate in the same manner as in Example 1, except for using 1,2-bis(diethoxyethylsilyl)ethane synthesized in Synthesis Example 9 (gas flow rate: 0.3 sccm) as the silica source, and p-xylene (gas flow rate: 0.6 sccm) as the pore-forming agent.

5.3.15. Example 11

A silicon-containing film (thickness: 0.5 micrometers) was deposited on a silicon substrate in the same manner as in Example 5, except for using 1,1,1,4,4-pentaethoxy-1,4-disilahexane synthesized in Synthesis Example 10 as the silica source, and cyclopentene oxide as the pore-forming agent (gas flow rate: 0.6 sccm).

5.3.16. Example 12

A silicon-containing film (thickness: 0.5 micrometers) was deposited on a silicon substrate in the same manner as in Example 6, except for using 3,3,6-triethoxy-6-ethyl-3,6-disilaoctane synthesized in Synthesis Example 11 as the silica source, and p-xylene as the pore-forming agent (gas flow rate: 0.6 sccm).

5.3.17. Example 13

A silicon-containing film (thickness: 0.5 micrometers) was deposited on a silicon substrate in the same manner as in Example 6, except for using 1,1,1,4-tetraethoxy-1,4-disilahexane synthesized in Synthesis Example 12 as the silica source, p-xylene as the pore-forming agent (gas flow rate: 0.6 sccm), and supplying $O_2$ gas at a flow rate of 1.0 sccm.

5.3.18. Comparative Example 5

A silicon-containing insulating film (thickness: 0.5 micrometers) was deposited on a silicon substrate in the same manner as in Example 10, except for using 1,2-bis(diethoxyethylsilyl)vinylene synthesized in Reference Synthesis Example 3 as the silica source.

5.3.19. Comparative Example 6

A silicon-containing insulating film (thickness: 0.5 micrometers) was deposited on a silicon substrate in the same manner as in Example 12, except for using [(triethylsilyl)ethyl]ethyldiethoxysilane synthesized in Reference Synthesis Example 4 as the silica source.

5.3.20. Example 14

A silicon-containing film (thickness: 0.5 micrometers) was deposited on a silicon substrate in the same manner as in Example 1, except for using bis(dimethoxymethylsilyl)methane synthesized in Synthesis Example 1 (gas flow rate: 0.06 sccm) and diethoxymethylsilane (gas flow rate: 0.24 sccm) as the silica source.

5.3.21. Example 15

A silicon-containing film (thickness: 0.5 micrometers) was deposited on a silicon substrate in the same manner as in Example 1, except for using bis(dimethoxymethylsilyl)methane synthesized in Synthesis Example 1 (gas flow rate: 0.24 sccm) and diethoxymethylsilane (gas flow rate: 0.06 sccm) as the silica source.

5.3.22. Example 16

A chemical vapor deposition material was prepared by mixing a mixture of bis(dimethoxymethylsilyl)methane synthesized in Synthesis Example 1 and diethoxymethylsilane (molar ratio: 20:80) with a pore-forming agent in a weight ratio of 1:1. A silicon-containing film (thickness: 0.5 micrometers) was deposited on a silicon substrate in the same manner as in Example 1, except for using the chemical vapor deposition material thus prepared as the silica source.

5.3.23. Example 17

A chemical vapor deposition material was prepared by mixing a mixture of bis(dimethoxymethylsilyl)methane synthesized in Synthesis Example 1 and diethoxymethylsilane (molar ratio: 80:20) with a pore-forming agent in a weight ratio of 1:1. A silicon-containing film (thickness: 0.5 micrometers) was deposited on a silicon substrate in the same manner as in Example 1, except for using the chemical vapor deposition material thus prepared as the silica source.

5.3.24. Example 18

A chemical vapor deposition material was prepared by mixing bis(dimethoxymethylsilyl)methane synthesized in Synthesis Example 1 and bicyclo[2.2.1]hepta-2,5-diene in a weight ratio of 1:1. A silicon-containing insulating film (thickness: 0.5 micrometers) was deposited on a silicon substrate using a dual-frequency plasma CVD apparatus (manufactured by Youtec Co., Ltd.), and the chemical vapor deposition material thus prepared (gas flow rate: 0.3 sccm) as a silica source (Ar gas flow rate: 100 sccm, RF upper shower head power: 300 W (27.12 MHz), lower substrate power: 150 W (380 kHz), substrate temperature: 300°C, reaction pressure: 10 Torr).

5.4. Evaluation results

Table 1 shows the evaluation results for the silicon-containing insulating films obtained in Examples 1 to 18 and Comparative Examples 1 to 6.

TABLE 1

| | Relative dielectric constant | Δk | Modulus of elasticity (GPa) | Hardness (GPa) | Chemical resistance | Ashing resistance |
|---|---|---|---|---|---|---|
| Example 1 | 2.39 | 0.14 | 15.3 | 1.5 | B | S |
| Example 2 | 2.36 | 0.12 | 14.8 | 1.5 | A | S |
| Example 3 | 2.35 | 0.13 | 16.5 | 1.6 | A | S |
| Example 4 | 2.39 | 0.13 | 16.5 | 1.6 | B | S |
| Example 5 | 2.41 | 0.12 | 13.5 | 1.1 | A | S |

(continued)

| | Relative dielectric constant | Δk | Modulus of elasticity (GPa) | Hardness (GPa) | Chemical resistance | Ashing resistance |
|---|---|---|---|---|---|---|
| Example 6 | 2.36 | 0.12 | 11.3 | 1.1 | A | S |
| Comparative Example 1 | 2.40 | 0.11 | 10.9 | 1.0 | D | C |
| Comparative Example 2 | 2.37 | 0.14 | 9.3 | 0.9 | A | S |
| Example 7 | 2.50 | 0.11 | 14.4 | 1.4 | A | S |
| Example 8 | 2.55 | 0.11 | 14.2 | 1.2 | A | S |
| Example 9 | 2.52 | 0.12 | 13.4 | 1.2 | A | S |
| Comparative Example 3 | 2.55 | 0.1 | 12.9 | 1.1 | D | C |
| Comparative Example 4 | 2.51 | 0.12 | 11.2 | 1.0 | A | S |
| Example 10 | 2.40 | 0.14 | 13.8 | 1.4 | B | A |
| Example 11 | 2.34 | 0.1 | 13.8 | 1.1 | A | A |
| Example 12 | 2.37 | 0.13 | 11.8 | 1.2 | A | A |
| Example 13 | 2.41 | 0.14 | 13.6 | 1.3 | A | A |
| Comparative Example 5 | 2.41 | 0.10 | 14.2 | 1.4 | C | C |
| Comparative Example 6 | 2.35 | 0.11 | 9.1 | 0.7 | A | A |
| Example 14 | 2.38 | 0.09 | 13.1 | - | A | S |
| Example 15 | 2.34 | 0.10 | 12.7 | - | A | S |
| Example 16 | 2.39 | 0.08 | 13.4 | - | A | S |
| Example 17 | 2.36 | 0.11 | 12.9 | - | A | S |
| Example 18 | 2.39 | 0.13 | 11.3 | - | - | - |

The silicon-containing films obtained in Examples 1 to 18 had excellent mechanical strength, a low difference Δk (i.e., an index of the relative dielectric constant and hygroscopicity), excellent chemical resistance, and excellent ashing resistance. The silicon-containing films of Examples 1 to 9 had excellent ashing resistance as compared with the silicon-containing films of Examples 10 to 13. This means that a film that is formed using a silicon compound that has an $Si-CH_2-Si$ backbone structure exhibits excellent ashing resistance as compared with a film that is formed using a raw material silicon compound that has an $Si-CH_2-CH_2-Si$ backbone structure. In particular, the films of Examples 2, 3, and 7 that were formed using an organosilicon compound in which the silicon atoms were bonded via a methylene chain, and each silicon atom was substituted with a monovalent hydrocarbon group (e.g., alkyl group having 1 to 4 carbon atoms, vinyl group, or phenyl group) had significantly superior chemical resistance and ashing resistance.

The silicon-containing film obtained in Comparative Example 1 had a relative dielectric constant and a difference Δk almost equal to those of the silicon-containing films obtained in Examples 1 to 6. However, the mechanical strength, the chemical resistance, and the ashing resistance of the film obtained in Comparative Example 1 were inferior to those of the silicon-containing films obtained in Examples 1 to 6. The silicon-containing film obtained in Comparative Example 2 had a relative dielectric constant, a difference Δk, chemical resistance, and ashing resistance almost equal to those of the silicon-containing films obtained in Examples 1 to 6. However, the mechanical strength of the film obtained in Comparative Example 2 was inferior to those of the silicon-containing films obtained in Examples 1 to 6.

The silicon-containing film obtained in Comparative Example 3 had a relative dielectric constant and a difference Δk almost equal to those of the silicon-containing film obtained in Example 7. However, the mechanical strength, the

chemical resistance, and the ashing resistance of the film obtained in Comparative Example 3 were inferior to those of the silicon-containing film obtained in Example 7. The silicon-containing film obtained in Comparative Example 4 had a relative dielectric constant, a difference Δk, chemical resistance, and ashing resistance almost equal to those of the silicon-containing films obtained in Examples 7 to 9. However, the mechanical strength of the film obtained in Comparative Example 4 was inferior to those of the silicon-containing films of Examples 7 to 9.

In Comparative Example 5, a film was formed using an organosilane compound obtained by substituting the ethylene chain of the organosilane compound used in
Example 10 with a vinylene chain. The film obtained in Comparative Example 5 had a relative dielectric constant, a difference Δk, and mechanical strength almost equal to those of the films obtained in Examples 10 to 13. However, the chemical resistance and the ashing resistance of the film obtained in Comparative Example 5 were inferior to those of the films obtained in Comparative Examples 10 to 13. The film obtained in Comparative Example 6 had a relative dielectric constant, a difference Δk, chemical resistance, and ashing resistance almost equal to those of the films obtained in Examples 10 to 13. However, the mechanical strength of the film obtained in Comparative Example 6 was inferior to those of the films of Examples 10 to 13.

As described above, since the silicon-containing films according to the embodiments of the invention have excellent mechanical strength, a low relative dielectric constant, excellent process resistance (e.g., hygroscopic resistance, chemical resistance, and ashing resistance), and excellent storage stability, the silicon-containing films according to the embodiments of the invention may be suitably used as an interlayer dielectric of semiconductor devices, etc.

Possible embodiments of the invention have been described above. The invention includes configurations substantially the same as the configurations described relating to the above embodiments (in function, in method and effect, or in objective and effect). The invention also includes a configuration in which an unsubstantial element of the above embodiments is replaced by another element. The invention also includes a configuration having the same effects as those of the configurations described relating to the above embodiments, or a configuration capable of achieving the same object as those of the above-described configurations. The invention further includes a configuration obtained by adding known technology to the configurations described in the above embodiments.

## Claims

1. A chemical vapor deposition material comprising an organosilane compound shown by the following general formula (1),

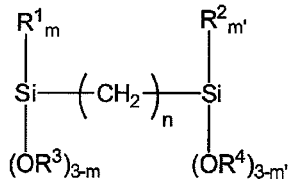

(1)

wherein $R^1$ and $R^2$ individually represent a hydrogen atom, an alkyl group having 1 to 4 carbon atoms, a vinyl group, or a phenyl group, $R^3$ and $R^4$ individually represent an alkyl group having 1 to 4 carbon atoms, an acetyl group, or a phenyl group, m and m' are individually integers from 0 to 2, and n is an integer from 1 to 3.

2. The chemical vapor deposition material according to claim 1, wherein m=m'.

3. The chemical vapor deposition material according to claim 2, wherein m=m'=1 or 2.

4. The chemical vapor deposition material according to claim 1, wherein m=0 and m'=1.

5. The chemical vapor deposition material according to claim 1, wherein m=2 and m'=0 or 1.

6. The chemical vapor deposition material according to any one of claims 1 to 5, wherein n=1.

7. The chemical vapor deposition material according to any one of claims 1 to 6, the material being used to form an insulating film that includes silicon, carbon, oxygen, and hydrogen.

**8.** The chemical vapor deposition material according to any one of claims 1 to 7, the material having a content of elements other than silicon, carbon, oxygen, and hydrogen of less than 10 ppb, and a water content of less than 0.1%.

**9.** A silicon-containing insulating film formed by using the chemical vapor deposition material according to any one of claims 1 to 8.

**10.** A method of producing a silicon-containing insulating film, the method comprising:

depositing the chemical vapor deposition material according to any one of claims 1 to 9 on a substrate by chemical vapor deposition to form a deposited film; and
curing the deposited film by at least one means selected from heating, electron beam irradiation, ultraviolet irradiation, and oxygen plasma irradiation.

**11.** A method of producing a silicon-containing insulating film, the method comprising supplying the chemical vapor deposition material according to any one of claims 1 to 9 and a pore-forming agent to a substrate by chemical vapor deposition to form a deposited film.

**12.** A silicon-containing insulating film obtained by the method of producing a silicon-containing insulating film according to claim 10 or 11.

**13.** The silicon-containing insulating film according to claim 9 or 12, the film including an $-Si-(CH_2)_n-Si-O-$site, wherein n is an integer from 1 to 3.

**14.** The silicon-containing insulating film according to any one of claims 9, 12, and 13, the film having a dielectric constant of 3.0 or less.

**INTERNATIONAL SEARCH REPORT**

International application No.
PCT/JP2009/055825

A. CLASSIFICATION OF SUBJECT MATTER
*C23C16/42*(2006.01)i, *C08G77/50*(2006.01)i, *H01L21/312*(2006.01)i, *H01L21/316*(2006.01)i, *H01L21/768*(2006.01)i, *H01L23/522*(2006.01)i

According to International Patent Classification (IPC) or to both national classification and IPC

B. FIELDS SEARCHED

Minimum documentation searched (classification system followed by classification symbols)
C23C16/00-16/56, C08G77/50, H01L21/312, H01L21/316, H01L21/768, H01L23/522, C07F7/18

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2009 |
| Kokai Jitsuyo Shinan Koho | 1971-2009 | Toroku Jitsuyo Shinan Koho | 1994-2009 |

Electronic data base consulted during the international search (name of data base and, where practicable, search terms used)
CA/REGISTRY(STN)

C. DOCUMENTS CONSIDERED TO BE RELEVANT

| Category* | Citation of document, with indication, where appropriate, of the relevant passages | Relevant to claim No. |
|---|---|---|
| X<br><br>Y | JP 2007-318067 A (Independent Administrative Institution National Institute for Materials Science), 06 December, 2007 (06.12.07), Claims 14 to 16; Par. Nos. [0053] to [0055] & JP 2007-318070 A & WO 2007/018268 A1 | 1-3,6,7,9, 12-14<br>8,10,11 |
| X<br>Y | JP 2005-019980 A (Air Products and Chemicals, Inc.), 20 January, 2005 (20.01.05), Par. Nos. [0014], [0052] & US 2004/0241463 A1 & EP 1482070 A1 & TW 250221 B & KR 10-2004-0104402 A & CN 1576390 A | 1-7,9,12-14<br>11 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 18 June, 2009 (18.06.09) | 30 June, 2009 (30.06.09) |
| Name and mailing address of the ISA/<br>Japanese Patent Office<br>Facsimile No. | Authorized officer<br><br>Telephone No. |

Form PCT/ISA/210 (second sheet) (April 2007)

**INTERNATIONAL SEARCH REPORT**

International application No.
PCT/JP2009/055825

C (Continuation). DOCUMENTS CONSIDERED TO BE RELEVANT

| Category* | Citation of document, with indication, where appropriate, of the relevant passages | Relevant to claim No. |
|---|---|---|
| Y | WO 2008/020592 A1 (JSR Corp.), 21 February, 2008 (21.02.08), All pages & EP 2053107 A | 8,10 |
| X | JP 2008-050341 A (Air Products and Chemicals, Inc.), 06 March, 2008 (06.03.08), Par. No. [0025] & US 2007/0287849 A1 & EP 1867653 A1 & KR 10-2007-0118979 A & CN 101092689 A | 1-3,5-7,9, 12-14 |
| X | JP 2006-216541 A (International Business Machines Corp.), 17 August, 2006 (17.08.06), Claim 30; Par. No. [0060] & US 2005/0194619 A1 & US 2006/0165891 A1 & CN 1819180 A | 1,2,7,9, 12-14 |
| A | JP 2005-350653 A (JSR Corp.), 22 December, 2005 (22.12.05), Par. Nos. [0059], [0074], [0075] & JP 2005-350651 A & US 2007/0020467 A1 & US 2008/0038527 A1 & EP 1746122 A1 & EP 1746139 A1 & WO 2005/108468 A1 & WO 2005/068540 A1 & WO 2005/068541 A1 & WO 2005/108469 A1 & WO 2005/108516 A1 & KR 10-2007-0010081 A & CN 1950473 A & CN 1954017 A | 1,4 |

Form PCT/ISA/210 (continuation of second sheet) (April 2007)

**INTERNATIONAL SEARCH REPORT**

International application No.
PCT/JP2009/055825

**Box No. II Observations where certain claims were found unsearchable (Continuation of item 2 of first sheet)**

This international search report has not been established in respect of certain claims under Article 17(2)(a) for the following reasons:

1. ☐ Claims Nos.:
because they relate to subject matter not required to be searched by this Authority, namely:

2. ☐ Claims Nos.:
because they relate to parts of the international application that do not comply with the prescribed requirements to such an extent that no meaningful international search can be carried out, specifically:

3. ☐ Claims Nos.:
because they are dependent claims and are not drafted in accordance with the second and third sentences of Rule 6.4(a).

**Box No. III Observations where unity of invention is lacking (Continuation of item 3 of first sheet)**

This International Searching Authority found multiple inventions in this international application, as follows:

The inventions of claims 1-7, 9, 12-14 are disclosed in a document (JP 2005-019980A) cited in this international search report, so that they have no special technical features.

Claims 8-14 relate to a material for chemical vapor deposition for the formation of insulating films which contains an organosilane represented by general formula (1) [wherein m=m'= 1 or 2 and n=1] and in which the content of elements exclusive of silicon, carbon, oxygen and hydrogen is less than 10 ppb and the water content is less than 0.1%.

Claim 4 relates to a material for chemical vapor deposition which contains

(continued to extra sheet)

1. ☐ As all required additional search fees were timely paid by the applicant, this international search report covers all searchable claims.

2. ☒ As all searchable claims could be searched without effort justifying additional fees, this Authority did not invite payment of additional fees.

3. ☐ As only some of the required additional search fees were timely paid by the applicant, this international search report covers only those claims for which fees were paid, specifically claims Nos.:

4. ☐ No required additional search fees were timely paid by the applicant. Consequently, this international search report is restricted to the invention first mentioned in the claims; it is covered by claims Nos.:

**Remark on Protest** the

☐ The additional search fees were accompanied by the applicant's protest and, where applicable, payment of a protest fee.

☐ The additional search fees were accompanied by the applicant's protest but the applicable protest fee was not paid within the time limit specified in the invitation.

☐ No protest accompanied the payment of additional search fees.

**INTERNATIONAL SEARCH REPORT**

International application No.
PCT/JP2009/055825

Continuation of Box No.III of continuation of first sheet(2)

an organosilane represented by general formula (1) wherein m=0 and m'=1.

Claim 5 relates to a material for chemical vapor deposition which contains an organosilane represented by general formula (1) wherein m=2 and m'=0 to 1.

Form PCT/ISA/210 (extra sheet) (April 2007)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 11288931 A
- JP 2002329718 A
- JP 2007318067 A
- WO 2008020592 A